# FASCICULE DE BREVET EUROPEEN

(11) **EP 2 720 057 B1**
(45) Date de publication et mention de la délivrance du brevet: **03.06.2015**
(21) Numéro de dépôt: 13186577.6
(22) Date de dépôt: 30.09.2013
(51) Int. Cl.: G01R 33/032, G01R 33/10

(54) **Surface magneto-optique**
Magneto-optische Ober-Fläche
Magnetic-optical surface

(30) Priorité: 15.10.2012 FR 1259791
(43) Date de publication de la demande: 16.04.2014
(73) Titulaire: COMMISSARIAT A L'ENERGIE ATOMIQUE ET AUX ENERGIES ALTERNATIVES, 75015 Paris (FR); Centre National de la Recherche Scientifique, 75794 Paris Cedex 16 (FR)
(72) Inventeur: Joisten, Hélène, 38000 Grenoble (FR); Dieny, Bernard, 38250 Villard de Lans (FR); Sabon, Philippe, 38420 Moirans (FR); Calemczuk, Roberto, 38000 Grenoble (FR)
(74) Mandataire: Lebkiri, Alexandre

(56) Documents cités:
- FR-A1- 2 958 791
- US-A1- 2004 239 936

## Description

### DOMAINE TECHNIQUE DE L'INVENTION

L'invention se rapporte à une surface magnéto-optique et également à un procédé de fabrication d'une telle surface magnéto-optique, ainsi qu'à l'utilisation d'une telle surface magnéto-optique.

On entendra par propriétés optiques de la surface dans le cadre de la présente demande les propriétés en réflexion, en transmission ou en émission de la surface.

### ETAT DE LA TECHNIQUE ANTERIEURE

Dans le domaine de la cartographie ou de l'imagerie de champ magnétique, il existe des méthodes différentes permettant de caractériser ou de visualiser des champs magnétiques.

Une première méthode connue de caractérisation de matériaux magnétiques, permettant de visualiser les domaines magnétiques desdits matériaux magnétiques, repose sur les effets magnéto-optiques de Kerr ou de Faraday. Un tel type de caractérisation de matériaux magnétiques est décrit dans le document D1 suivant : Anjan Barman, T. Kimura, Y. Otani, Y. Fukuma, K. Akahane et al., « Benchtop time-resolved magneto-optical Kerr magnetometer », Rev. Sci. Instrum. 79, 123905 (2008). L'effet Kerr consiste à étudier les modifications en réflexion d'une lumière polarisée par un matériau magnétique et l'effet Faraday consiste à étudier les modifications en transmission d'une lumière polarisée par un matériau magnétique. Le contraste de l'imagerie est lié à l'orientation de l'aimantation dans le matériau. Ces deux effets peuvent aussi permettre dans certaines expériences, la visualisation de champs magnétiques externes, qui agissent sur l'aimantation de l'échantillon. Ils peuvent de cette manière donner une forme d'image du champ magnétique ambiant. Mais ces effets sont indirects et nécessitent l'éclairage de l'échantillon magnétique par une lumière polarisée, les images des domaines magnétiques étant visualisées en mesurant la rotation de la polarisation de la lumière, traduisant l'orientation de l'aimantation. L'étude de champs magnétiques par ces méthodes demande un montage optique coûteux et encombrant avec analyseur et polariseur.

Une autre méthode connue permettant également de visualiser optiquement des informations sur l'intensité et la direction de champs magnétiques appliqués dans l'espace est l'utilisation de matériaux ferrofluides tel que décrit dans le document D2 suivant : A Siblini, J Monin, G Noyel and O Brevet-Philibert, « An AC magnetic field remote sensor using a ferrofluid material: application to the measurement of off-centring sleeves of HV transmission lines », Meas. Sci. Technol. 3 1068 (1992). Dans ce document, sont utilisées des particules magnétiques dispersées en solution colloïdale dans un fluide. Le champ magnétique est visualisé par les amoncellements de particules magnétiques, qui se déplacent, se regroupent, et s'agglomèrent vers des zones de plus forts gradients de champs magnétiques et de forts champs. Ce sont leurs répartitions et concentrations dans l'espace qui donnent les informations sur le champ magnétique à observer et forment une cartographie des lignes de champ. Cette méthode présente l'inconvénient de nécessiter l'utilisation peu pratique de matériaux ferrofluides ou en poudre, non réutilisables car souvent non réversibles. De plus, ces matériaux ont en général une susceptibilité magnétique faible. Les documents suivants de l'état de la technique sont aussi pertinents : (1) FR 2 958 791 A1, (2) US 2004/239936 A1.

### EXPOSE DE L'INVENTION

L'invention vise à remédier à tout ou partie des inconvénients de l'état de la technique identifiés ci-dessus, et notamment à proposer des moyens alternatifs peu coûteux et peu encombrants permettant de cartographier un champ magnétique.

Dans ce dessein, un aspect de l'invention se rapporte à une surface magnéto-optique comportant :
- un support ;
- au moins deux éléments mobiles ;
chacun desdits éléments mobiles comportant :
- au moins un point d'ancrage au support;
- au moins une partie mobile par rapport au support, ladite partie mobile comportant au moins une partie magnétique ;
le support et lesdits éléments mobiles étant agencés de façon à ce que sous l'effet d'un champ magnétique extérieur, au moins un desdits éléments mobiles se déplace par rapport au support de sorte que les propriétés optiques de la surface magnéto-optique sont modifiées.

Ceci a pour avantage de permettre de détecter un champ magnétique extérieur, de visualiser sa nature, ses variations et/ou de le cartographier, sous la forme d'une image. Les contrastes ou couleurs de l'image dépendent des caractéristiques - intensité et direction - du champ magnétique en tout point de l'image. En effet, sous l'effet du champ magnétique extérieur, la partie magnétique des éléments mobiles, comprise dans la partie mobile de ces éléments mobiles, va s'orienter selon le champ magnétique extérieur ce qui entraine un déplacement, par rapport au support, des éléments mobiles, et plus particulièrement de la partie mobile des éléments mobiles. Le champ magnétique extérieur peut provoquer localement la distorsion, le déplacement, la réorientation de chaque élément mobile individuellement. Ces éléments mobiles sont actionnables à distance par un (ou des) champ magnétique extérieur, en réagissant aux couples et aux forces magnéto-mécaniques créés par le champ magnétique extérieur et/ou par son gradient. Le déplacement d'au moins un élément mobile par rapport au support se traduit visuellement par une modification des propriétés optiques de la surface. Les mouvements individuels des éléments mobiles ont un effet global sur la surface. Les propriétés optiques de la surface, éclairée par une source lumineuse extérieure quelconque (lumière naturelle ou artificielle), modifiées sont les propriétés en réflexion, en transmission ou en émission de la lumière. Ces modifications sont visibles par un récepteur, qui est soit l'oeil nu, soit un microscope ou encore un moyen artificiel de vision, par exemple un détecteur optique captant l'image de la surface magnéto-optique. Chaque élément mobile peut réagir différemment si le champ magnétique n'est pas uniforme dans l'espace, ou évolue dans le temps, et réagir différemment de son voisin. L'observation et/ou l'analyse des modifications de l'image de la surface magnéto-optique entre un état initial, correspondant à une première position d'équilibre des éléments mobiles, et un état intermédiaire, correspondant à une deuxième position d'équilibre des éléments mobiles, permettent de visualiser et/ou de cartographier un champ magnétique extérieur auquel est soumis la surface magnéto-optique et auquel sont sensibles les parties magnétiques des parties mobiles des éléments mobiles. La notion d'agencement du support et des éléments mobiles englobe leur positionnement les uns par rapport aux autres, mais aussi les matériaux dont ils sont constitués. La partie mobile des éléments mobiles est libre de rester flottante ou en tension ou repose sur le support ou peut pendre dans le cas où la surface est retournée. Dans le cas où la surface est de dimension macroscopique, le phénomène microscopique devient visible dans l'image de la surface, par ses propriétés optiques modifiées. Les éléments mobiles peuvent ne pas être individuellement discernables à l'oeil nu ou au microscope, à cause de leurs petites dimensions micro / ou nanométriques. Mais bien qu'invisibles sur la surface du substrat, les éléments mobiles créent une information visible, caractéristique du champ magnétique appliqué qui les actionnent. Ils réfléchissent, transmettent ou émettent la lumière différemment selon leurs orientations. De manière analogue aux pixels de l'imagerie numérique, chaque surface élémentaire contenant un seul élément mobile, représente la plus petite contribution à la visualisation du champ magnétique. Cette plus petite dimension de surface permet de donner la limite de résolution spatiale de la visualisation du champ magnétique. La définition et la résolution de l'image du champ magnétique appliqué (nombre de points qui la compose, ou nombre de pixels par unité de surface), dépend de la densité de population des éléments mobiles sur la surface de l'objet, de leur dimension, du pas qui les sépare, et du rapport de ces dimensions à la taille de surface observée.

Outre les caractéristiques principales qui viennent d'être mentionnées dans le paragraphe précédent, la surface magnéto-optique selon l'invention peut présenter une ou plusieurs caractéristiques complémentaires parmi les suivantes, considérées individuellement ou selon les combinaisons techniquement possibles :
- le support est transparent à la lumière émise par une source lumineuse extérieure et les propriétés optiques de la surface magnéto-optique modifiées sont les propriétés en transmission de ladite lumière. Ainsi, par exemple, en positionnant le support de façon à faire pendre les éléments mobiles, lesdits éléments mobiles sont visibles par transparence en transmission de la lumière émise par la source lumineuse extérieure ;
- le support est opaque à la lumière émise par une source lumineuse extérieure et en ce que les propriétés optiques de la surface magnéto-optique modifiées sont les propriétés en réflexion de ladite lumière. Les propriétés en réflexion de la surface sont observables en regardant la face sur laquelle sont ancrés les éléments mobiles par-dessus. Le support peut ainsi sembler devenir transparent à la lumière, observé en réflexion. En effet, un objet placé au-dessous du support opaque est invisible. Mais si cet objet est une source de champ magnétique, par exemple un aimant, il devient visible en regardant la surface du substrat par-dessus ;
- la partie mobile par rapport au support de chacun desdits éléments mobiles comporte un moyen d'émission de lumière. Dans ce cas, ce sont les propriétés en émission de lumière de la surface qui sont modifiées sous l'action d'un champ magnétique extérieur. Le moyen d'émission de la lumière peut être une diode électroluminescente (LED), une diode électroluminescente organique (OLED), une diode laser, etc... La direction de la lumière émise dépend du champ magnétique extérieur dans lequel est plongée la surface magnéto-optique ;
- le support comporte une source d'alimentation électrique et en ce que le moyen d'émission de lumière de chacun desdits éléments mobiles est relié à la source d'alimentation électrique par un élément de connectique. Le moyen d'émission de lumière de la partie mobile peut être relié, par l'élément de connectique, à la source d'alimentation électrique du support en passant par le point d'ancrage au support de l'élément mobile. L'élément de connectique peut aussi être une partie conductrice électriquement de l'élément mobile réalisée en utilisant un matériau du type Cuivre (Cu), Aluminimum (Al), Chrome (Cr), alliage Nickel-Fer (NiFe)...;
- la partie mobile de chacun desdits éléments mobiles comporte une partie flexible. La présence d'une partie flexible permet d'améliorer l'efficacité du dispositif en facilitant le déplacement de la partie mobile sous l'effet d'un champ magnétique extérieur. Plus la partie mobile est flexible, plus l'élément mobile est sensible à des champs magnétiques extérieurs faibles. La flexibilité dépend des compositions, matériaux utilisés, de leurs propriétés mécaniques, notamment de leurs modules d'Young, des géométries, dimensions, rapports de formes, des liens à la surface, ainsi que des tensions internes présentes dans les matériaux utilisés ;
- la partie mobile de chacun desdits éléments mobiles comporte une pluralité de parties flexibles reliées les unes aux autres par des parties moins flexibles. Cette configuration permet d'améliorer la flexibilité de la partie mobile de l'élément mobile et donc l'efficacité de la surface magnéto-optique grâce à l'ajout de degrés de liberté à la partie mobile de l'élément mobile ;
- la partie mobile de chacun desdits éléments mobiles comporte une partie réfléchissante. Ceci permet d'améliorer l'efficacité de la surface magnéto-optique. Plus la partie réfléchissante de la partie mobile occupe une proportion importante de la surface, plus l'efficacité de la surface magnéto-optique est améliorée. En améliorant les propriétés réfléchissantes de la partie mobile, en particulier sa réflectivité, la détection des modifications des propriétés optiques de la surface est plus aisée.
- le point d'ancrage au support est un axe fixe et en ce que l'élément mobile est mobile en rotation autour de cet axe fixe sous l'effet du champ magnétique extérieur.
- les éléments mobiles sont agencés de sorte qu'ils se déplacent selon un même vecteur sous l'effet d'un champ magnétique extérieur homogène. Ainsi les éléments mobiles, sous l'effet d'un champ magnétique extérieur homogène se déplacent de la même façon par rapport au support de la surface magnéto-optique : les vecteurs déplacement de chacun des éléments mobiles ont même sens, même direction et même norme. Ainsi, dans cette configuration, les éléments mobiles des deux sous-ensembles ont un comportement identique quand ils sont soumis au même champ magnétique. La réflectivité est modifiée, le phénomène est plus marqué pour une direction privilégiée d'observation de la plaque.
- la surface magnéto-optique comporte un premier sous-ensemble comportant au moins deux éléments mobiles, les éléments mobiles du premier sous-ensemble se déplaçant selon un même premier vecteur sous l'effet d'un champ magnétique extérieur homogène ; et un deuxième sous-ensemble comportant au moins deux éléments mobiles, les éléments mobiles du deuxième sous-ensemble se déplaçant selon un même deuxième vecteur sous l'effet d'un champ magnétique extérieur homogène.

L'invention se rapporte également à un procédé de fabrication d'une surface magnéto-optique selon l'un des modes de réalisation précédemment décrit, ledit procédé comportant :
- une étape de dépôt sur le support d'une couche de matériau sacrificiel ;
- une étape de réalisation d'un réseau de trous dans le matériau sacrificiel, les trous ayant la forme voulue des éléments mobiles ;
- une étape de dépôt des matériaux constituant lesdits éléments mobiles, lesdits matériaux étant déposés sur l'ensemble du support ;
- une étape de retrait du matériau sacrificiel, de façon à ce que seuls les éléments mobiles restent sur le support ; et
- une étape de libération des parties mobiles du support tout en conservant un point d'ancrage au support.

L'invention se rapporte également à un procédé de cartographie d'un champ magnétique, ledit champ magnétique étant dans une zone, ledit procédé comprend les étapes suivantes :
- une étape au cours de laquelle une surface magnéto-optique selon l'un des modes de réalisations précédemment décrits est disposée dans ladite zone ;
- une étape d'observation de l'image de la surface magnéto-optique, l'amplitude des déflections locales de la lumière issue de ladite surface magnéto-optique étant l'image de la distribution spatiale du champ magnétique, ladite surface magnéto-optique étant éclairée par une source lumineuse.

L'observation de l'image de la surface magnéto-optique modifiée sous l'effet du champ magnétique extérieur permet d'avoir une image des caractéristiques de ce champ magnétique.

L'invention se rapporte également à un procédé de détection d'inhomogénéité de conductivité électrique dans un objet électriquement conducteur, ledit procédé comportant les étapes suivantes :
- une étape d'injection d'un courant dans l'objet électriquement conducteur ;
- une étape d'observation d'une surface magnéto-optique selon l'un des modes de réalisations précédemment décrits, ladite surface magnéto-optique étant disposée au-dessus dudit objet et ladite surface magnéto-optique étant éclairée par une source lumineuse, ladite étape d'observation étant réalisée par un récepteur ;
une inhomogénéité en une zone de l'objet étant détectée par une modification des propriétés optiques de la surface magnéto-optique au niveau de ladite zone de l'objet sous l'action de la modification du champ magnétique engendrée par la déviation du courant par ladite inhomogénéité. La source lumineuse extérieure peut être une source de lumière naturelle ou artificielle. L'observation de la surface magnéto-optique se fait par un récepteur qui peut être l'oeil nu, au microscope ou un détecteur optique.

L'invention se rapporte également à un réseau de diffraction comportant une surface magnéto-optique selon l'un des modes de réalisation précédemment décrits, les éléments mobiles ont la même forme et les mêmes dimensions et sont agencés de façon à diffracter une lumière émise par une source lumineuse extérieure.

### BREVE DESCRIPTION DES FIGURES

D'autres caractéristiques et avantages de l'invention ressortiront à la lecture de la description qui suit, en référence aux figures annexées, qui illustrent :
- la figure 1, une vue schématique d'une surface magnéto-optique selon un mode de réalisation de l'invention ;
- les figures 2A, 2B et 2C, des vues schématiques de trois variantes de réalisation d'un élément mobile d'une surface magnéto-optique ;
- les figures 3A, 3B et 3C, des vues schématiques d'une variante de réalisation d'un élément mobile d'une surface magnéto-optique. La figure 3A étant une vue de côté de l'élément mobile, le champ magnétique extérieur étant nul ; la figure 3B étant la vue de côté de l'élément mobile, le champ magnétique extérieur étant non nul ; la figure 3C étant une vue de dessus de l'élément mobile ;
- les figures 4A et 4B des vues obtenues par détecteur optique d'une surface magnéto-optique selon un mode de réalisation de l'invention. La figure 4B étant une vue agrandie d'une zone de la surface optique de la figure 4A ;
- les figures 5A, 5B et 5C, des vues schématiques de trois variantes de réalisation d'une surface magnéto-optique soumise à un champ magnétique extérieur nul ;
- les figures 6A et 6B, des vues schématiques de trois variantes de réalisation d'une surface magnéto-optique soumise à un champ magnétique extérieur nul ;
- la figure 7A, une vue schématique d'une surface magnéto-optique selon un mode de réalisation de l'invention soumise à un champ magnétique extérieur nul et la figure 7B, une vue schématique de la cartographie du champ magnétique extérieur (ici nul) observé par un récepteur disposé au-dessus de la surface magnéto-optique de la figure 7A ;
- les figures 8A et 8B, respectivement, une vue schématique de la surface magnéto-optique de la figure 7A soumise à un champ magnétique extérieur non nul et une vue schématique de la cartographie du champ magnétique extérieur non nul observé par un récepteur disposé au-dessus de la surface magnéto-optique de la figure 8A;
- la figure 9A, une vue schématique d'une surface magnéto-optique selon un mode de réalisation de l'invention soumise à un champ magnétique extérieur nul et la figure 9B, une vue schématique de la cartographie du champ magnétique extérieur (ici nul) observé par un récepteur disposé au-dessus de la surface magnéto-optique de la figure 9A ;
- les figures 10A et 10B, respectivement, une vue schématique de la surface magnéto-optique de la figure 9A soumise à un champ magnétique extérieur non nul et une vue schématique de la cartographie du champ magnétique extérieur non nul observé par un récepteur disposé au-dessus de la surface magnéto-optique de la figure 10A ;
- les figures 11A à 11C, des vues obtenues par un détecteur optique d'une surface magnéto-optique selon un mode de réalisation de l'invention, ladite surface étant soumise à un champ magnétique extérieur nul (figure 11 A) et non nul (cas des figures 11B et 11C) ;
- la figure 12A, une vue schématique des étapes d'un procédé de fabrication d'une surface magnéto-optique selon un mode de réalisation de l'invention et la figure 12B, une vue schématique de dessus de la surface magnéto-optique obtenue par le procédé de fabrication de la figure 12A ;
- les figures 13A à 13H, des vues schématiques de différentes variantes de réalisation d'un élément mobile d'une surface magnéto-optique ;
- les figures 14A et 14B, des vues schématiques de variantes de réalisation d'une surface magnéto-optique ;
- les figures 15A à 15C, des vues schématiques de différentes variantes de réalisation d'un élément mobile d'une surface magnéto-optique. Chacune des figures 15A à 15C étant une vue de l'élément mobile soumis à un champ extérieur nul ou soumis à un champ extérieur non nul ;
- les figures 16A à 16C, des vues schématiques d'un même élément mobile d'une surface magnéto-optique selon un mode de réalisation de l'invention, chacune des figures 16A à 16C étant une vue de l'élément mobile soumis à un champ extérieur nul ou soumis à un champ extérieur non nul ;
- les figures 17A et 17B, des vues schématiques d'une surface magnéto-optique selon un mode de réalisation de l'invention et les figures 17C à 17E des vues schématiques de variantes de réalisation d'un élément mobile d'une surface magnéto-optique ; et
- la figure 18 un schéma d'une plaque métallique et d'une surface magnéto-optique selon un mode de réalisation de l'invention.

Pour plus de clarté, les éléments identiques ou similaires sont repérés par des signes de référence identiques sur l'ensemble des figures.

Un repère cartésien (0 ; x, y, z) est représenté sur certaines figures afin d'aider à une meilleure compréhension.

### DESCRIPTION DETAILLEE D'UN MODE DE REALISATION

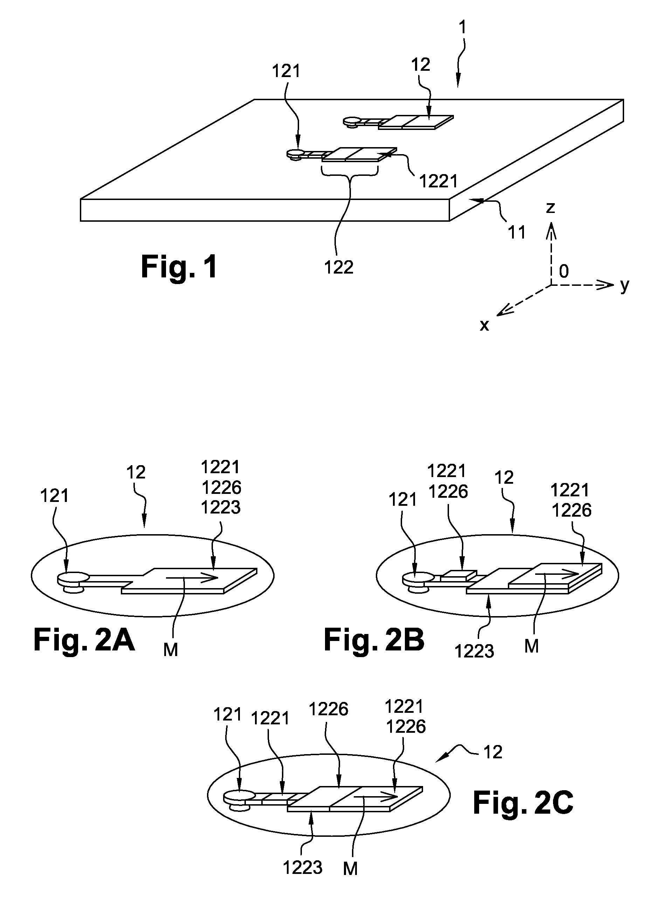

La figure 1 représente une surface magnéto-optique 1 comportant un support 11 et deux éléments mobiles 12.

Le support 11 peut être opaque (par exemple en silicium) ou transparent (par exemple en verre, en quartz) ; et peut être solide ou souple (par exemple en polymère). Il est constitué par exemple d'un substrat mince de silicium ou de verre ou quartz, matériau facilement compatible avec les techniques de fabrication micro- ou nanoélectroniques (dans le cas où les éléments mobiles sont de taille microscopique ou nanoscopique), mais également de tout autre matériau et provenant de toute autre technique de fabrication.

Les deux éléments mobiles 12 sont ancrés à la surface du support 11 par un point d'ancrage 121 et leur partie mobile 122 est libre de se mouvoir par rapport au support. Les éléments mobiles 12 sont ainsi partiellement détachés du support 11, et partiellement ancrés au support 11.

La partie mobile 122 des éléments mobiles comporte une partie magnétique 1221, dont le moment magnétique est représenté par une flèche sur les figures. Les parties mobiles 122 des éléments mobiles 12 de la figure 1 comportent deux parties magnétiques 1221. Le moment magnétique des parties magnétiques 1221 tend à s'aligner sur le vecteur d'aimantation d'un champ magnétique extérieur, ce qui entraine un déplacement, par rapport au support 11, de la partie mobile 122 des éléments mobiles 12 sous l'effet du champ magnétique extérieur. Ce déplacement des éléments mobiles 12 modifie l'image de la surface magnéto-optique 1 observable par un récepteur.

Les formes des éléments magnétiques mobiles sont quelconques, du simple filament, appendice, ou poutre magnétique, de la pastille, à des formes variées plus complexes, telles que triangles, croix, étoiles, ou toute autre forme, ou par exemple géométries à plusieurs branches. Cependant, ces éléments sont de préférence optimisés pour donner à la partie libérée : une bonne mobilité, flexibilité, souplesse ; une surface réfléchissante suffisante ; et un magnétisme suffisant pour l'actionnement par un champ magnétique extérieur.

Les figures 2A à 2C représentent des variantes de réalisation d'éléments mobiles 12.

L'élément mobile 12 de la figure 2A est composé d'un matériau d'un seul tenant. Le matériau d'un seul tenant est magnétique 1221, flexible 1223 et réfléchissant 1226, par exemple un alliage Nickel-Fer (NiFe). Il est attaché au support 11 par un point d'ancrage 121 composé d'une partie de l'élément mobile 12 et d'un plot qui la solidarise au support.

L'élément mobile 12 de la figure 2B est composé d'une couche flexible 1223 non magnétique supportant des plots de matériau magnétique et réfléchissant 1221, 1226. Le point d'ancrage au support 121 est ici réalisée dans un matériau distinct de la partie mobile 122 et comporte un plot qui le solidarise au support 11.

L'élément mobile de la figure 2C est composé d'une sous-couche mince flexible 1223 sur laquelle sont déposés des matériaux magnétiques 1221 et/ou réfléchissants 1226 et/ou flexibles.

La flexibilité est obtenue pour des matériaux de module d'Young peu élevé. Par exemple, une couche d'Aluminium est plus flexible qu'une couche de NiFe de même géométrie, en effet :
- Module d'Young Al : 69 GPa ;
- Module d'Young Fe : 196 GPa ; et
- Module d'Young Ni : 214 GPa.

Si l'élément mobile est déposé sur le support dans le plan xOy (cas de la figure 1 par exemple), pour obtenir une bonne flexibilité dans le plan vertical yOz, l'épaisseur selon Oz peut être minimisée et la longueur selon Oy maximisée. Un exemple de réalisation d'un tel élément mobile flexible est le suivant : une sous-couche mince d'Aluminium (d'épaisseur 60 nm, longueur 100 µm, largeur 5 µm) est suffisamment flexible et elle peut supporter par partie seulement des plots plus épais de NiFe magnétiques (d'épaisseur 120 nm), matériau NiFe qui rendrait l'élément plus rigide s'ils étaient déposés avec 120 nm d'épaisseur sur tout la surface mobile. Par contre des plots de NiFe d'épaisseur 120 nm et de surface seulement 5 µm x 5 µm déposés sur la sous-couche flexible d'Aluminium, n'entravent pas la flexibilité de l'Aluminium, et produisent des forces magnétiques suffisantes pour actionner l'élément mobile.

Tout matériau flexible et suffisamment résistant, non cassant, pouvant supporter le dépôt de matériaux magnétiques peut être utilisé pour former une partie flexible de la partie mobile :
- couches métalliques suffisamment minces : métaux de plus faibles modules d'Young que les matériaux magnétiques utilisés (Al, Au, Mg ...) ;
- alliages (alliages de Cu..) ;
- polymers ;
- résines ;
- matériaux biologiques (ADN ...) ; etc...

Dans le but d'obtenir une sensibilité et une réactivité suffisante des éléments mobiles au champ magnétique extérieur, donner une forme allongée aux éléments mobiles est particulièrement bien adapté. En effet, un matériau magnétique allongé a pour avantage d'avoir une anisotropie de forme et donc une aimantation orientée le long de la grande direction, d'où un couple magnétique efficace pour orienter le matériau sous l'effet d'un champ magnétique extérieur.

Plus le champ appliqué à cartographier est faible, plus la sensibilité des éléments mobiles doit être importante. Une grande sensibilité à un champ magnétique faible nécessite :
- une grande flexibilité, souplesse mécanique ;
- une grande aimantation et susceptibilité magnétique des matériaux magnétiques ;
- peu de contraintes mécaniques internes s'opposant à l'action magnéto-mécanique.

Des exemples de matériaux magnétiques présentant de telles caractéristiques sont :
- les matériaux magnétiques durs du type :
   - aimants, par exemple NdFeBr ;
   - matériaux multicouches magnétiques - matériau ferromagnétique, ou SAF (synthétique antiferromagnétique) - couplé à un matériau antiferromagnétique ;
- les matériaux magnétiques doux du type Permalloy (NiFe), CoFeB..
- des empilements magnétiques du type :
   - mono ou multicouches ; notamment couplés à travers des espaceurs non magnétiques ;
   - SAF (synthétique antiferromagnétiques) ;
   - Superparamagnétiques (par exemple NiFe de diamètres quelques nanomètres) ;
- également des matériaux magnéto-élastiques ou magnétostrictifs...

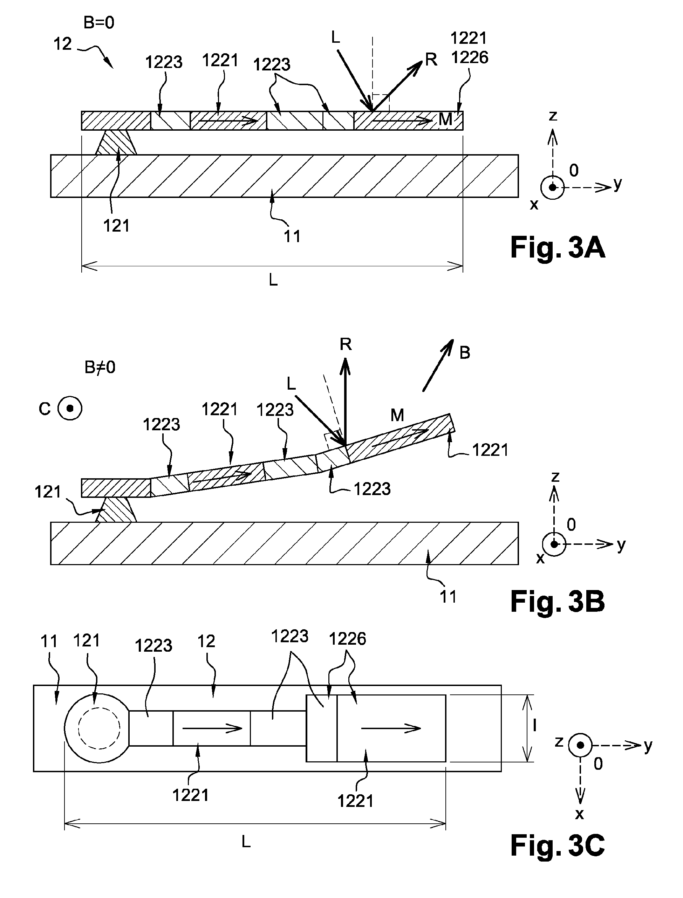

En outre, afin d'améliorer la flexibilité et la souplesse de la partie mobile de l'élément mobile, il est adapté que sa largeur soit très inférieure à sa longueur. Une partie mobile ayant une surface plane et large permet en outre une bonne réflexion de la lumière. Les figures 3A à 3C illustrent un élément mobile 12 ayant de telles caractéristiques.

L'élément mobile 12 des figures 3A à 3C a deux parties magnétiques 1221 allongées, présentant une anisotropie de forme (leur moment magnétique M est représenté par une flèche et orienté dans le sens de la longueur L de l'élément mobile 12). La largeur I la plus élevée de la partie mobile 122 de l'élément mobile 12 est bien inférieure à la longueur L de l'élément mobile 12, ceci est particulièrement visible sur la figure 3C qui est une vue de dessus de l'élément mobile 12 et du support 11. Ceci a pour avantage d'améliorer la flexibilité et la souplesse de la partie mobile 122 de l'élément mobile 12 et ainsi la détection de champ magnétique faible plus aisée. En outre, l'élément mobile 12 des figures 3A à 3C comporte plusieurs parties flexibles 1223 reliées entre elles par des sous parties moins flexibles (entre autres les parties magnétiques 1221) dans une configuration de type « cantilever ». La partie réfléchissante 1226 de l'élément mobile 12 a une surface plus élevée que le reste de l'élément ce qui a pour effet d'améliorer la réflexion de la lumière et d'améliorer la détection des modifications de l'image de la surface magnéto-optique sous l'effet d'un champ magnétique extérieur. Afin d'améliorer encore plus le contraste, et donc de faciliter la détection des modifications de l'image de la surface magnéto-optique sous l'effet d'un champ magnétique extérieur, le support 11 peut être, de façon particulièrement avantageuse, absorbant. Ainsi, en disposant un élément mobile 12, dont la partie réfléchissante 1226 a une surface plus élevée que le reste de l'élément mobile 12, sur un support absorbant, la détection des modifications de l'image de la surface magnéto-optique sous l'effet d'un champ magnétique extérieur sera améliorée. On peut également, à l'inverse du cas précédent, utiliser des éléments mobiles 12 absorbants, disposés sur un support 11 entièrement réfléchissant, ce qui a pour effet d'améliorer la détection des modifications de l'image de la surface magnéto-optique sous l'effet d'un champ magnétique extérieur. La figure 3A représente l'élément mobile 12 soumis à un champ magnétique extérieur nul (B=0), il se trouve dans une première position d'équilibre. Un faisceau lumineux incident L se réfléchit sur la partie mobile 12 en un faisceau lumineux réfléchi R. Le faisceau lumineux incident L provient d'une source lumineuse extérieure (naturelle ou artificielle) et le faisceau lumineux réfléchi R est observable par un récepteur.

La figure 3B représente le même élément mobile 12, soumis à un champ magnétique extérieur non nul (B≠0), dont le vecteur d'aimantation B est représenté par une flèche sur la figure 3B. Les deux parties magnétiques 1221 ont un moment magnétique M et un volume V. Sous l'effet du champ magnétique extérieur B, le moment magnétique de chacune de ces parties magnétiques 1221 cherche à s'aligner sur le vecteur d'aimantation B, entrainant les parties magnétiques 1221 qui se déplacent de façon à orienter leur moment magnétique M selon B et les parties magnétiques 1221 entrainent un déplacement de la partie mobile 12 relativement par rapport au support 11. Le couple magnéto-mécanique C à l'origine du déplacement d'une partie magnétique 1221 est proportionnel au moment magnétique M de cette partie magnétique 1221, au volume V de cette partie magnétique 1221 et à la valeur B du vecteur d'aimantation auquel est soumise la partie magnétique 1221. Seule la partie mobile 12 se déplace par rapport au support sous l'effet du champ magnétique extérieur B, le point d'ancrage 121 reste fixe par rapport au support. La figure 3B correspond à une deuxième position d'équilibre de l'élément mobile 12 après le déplacement de la partie mobile 122 de l'élément mobile 12 sous l'action du champ magnétique extérieur B. Le faisceau lumineux réfléchi R est dévié par rapport à la figure 3A, ainsi l'image observable par un récepteur R de la surface magnéto-optique comportant le support 11 et l'élément mobile 12 est modifiée. Cette modification de l'image est le signe de la présence d'un champ magnétique extérieur.

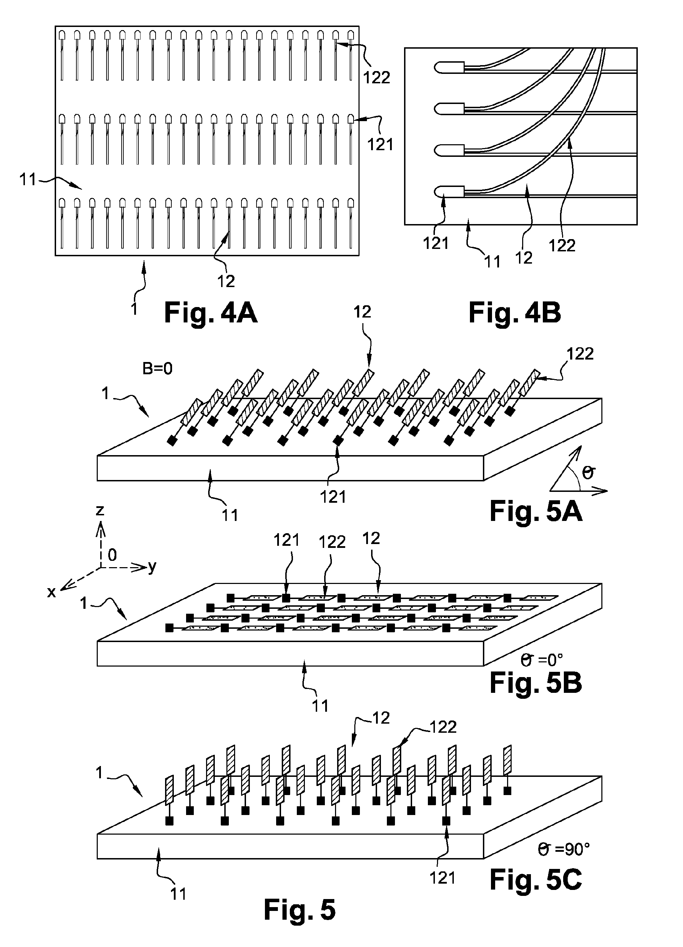

La figure 4A est une photo par microscopie optique d'une surface magnéto-optique 1 comportant un support 11 et des éléments mobiles 12 de taille microscopique (longueur l de la partie mobile 12 de 60µm). La figure 4B est une photo par microscope électronique à balayage d'une zone de la surface magnéto-optique de la figure 4A. Sur ces figures, la surface magnéto-optique est soumise à un champ magnétique extérieur nul. Les éléments mobiles 12 sont fixés au support par leur point d'ancrage au support 121. Dans cette première position d'équilibre pour un champ magnétique extérieur nul, la partie mobile 122 des éléments mobiles est orientée vers le haut (à l'opposé du support 11). Cela est dû aux tensions internes des matériaux constituant ces éléments (ici en NiFe) qui les orientent spontanément vers le haut.

Les figures 5A à 5C sont des vues schématiques d'une surface magnéto-optique 1 lorsque le champ magnétique extérieur est nul B=0. L'angle θ repère l'inclinaison des éléments mobiles 12 par rapport au plan du support 11, en champ nul. Entre les trois figures 3A à 3C, l'angle θ est différent. En effet, cet angle varie en fonction des tensions internes et des forces extérieures (par exemple dues au milieu dans lequel est plongée la surface magnéto-optique 1) agissant sur les parties mobiles 122 des éléments mobiles 12. Les tensions sont intrinsèques aux matériaux, ou bien peuvent être dues aux différences de tensions entre les couches de différents matériaux superposés. Sur les figures 5A à 5C, pour un champ magnétique extérieur nul, les éléments mobiles 12, ancrés au support par leur point d'ancrage 121, sont orientés selon les z>0. Ce mode de réalisation convient aussi bien à un fonctionnement dans lequel les propriétés de la surface sont modifiées en réflexion qu'à un fonctionnement dans lequel les propriétés de la surface sont modifiées en transmission. En réflexion, la source de lumière et le récepteur seront placés tous les deux du côté de face de la surface magnéto-optique où se trouvent les éléments mobiles (dans le cas de la figure 5, côté z>0), le support étant quelconque. En réflexion, dans le cas où le support est opaque, le récepteur doit être placé au-dessus de la surface magnéto-optique 1, c'est-à-dire sur l'axe z>0 (cas de la figure 5) pour une hauteur z supérieure à celle de la surface 1. En transmission, la source de lumière et le détecteur optique seront placés de part et d'autre de la surface : dans le cas de la figure 5, la source de lumière est située du côté des z<0 et le récepteur du côté des z>0, le support devant être transparent dans le cas d'une utilisation en transmission.

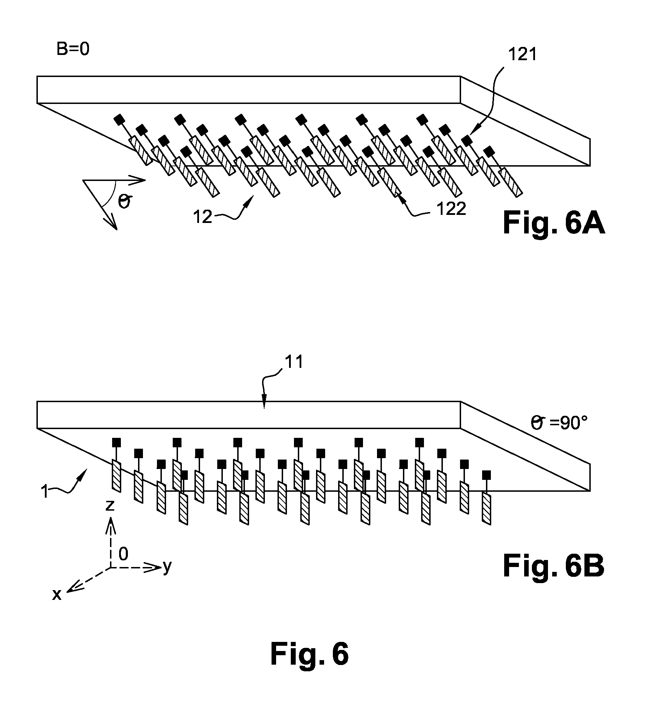

Dans le cas des figures 5A, 5C, et éventuellement 5B, les éléments mobiles 12 doivent être suffisamment rigides afin de rester dans la position souhaitée en contrant leur propre poids. Ils doivent donc être dimensionnés pour résister à la gravité. Cette augmentation de leur dimension et/ou cette augmentation de leur raideur, afin de résister à la gravité, dégrade leur capacité à se déformer sous l'effet d'un champ magnétique et donc dégrade leur sensibilité à un champ magnétique extérieur. Afin de remédier à ce problème, il peut être avantageux de placer les éléments mobiles sur la face du dessous (sur les figures 5A, 5B, 5C, du côté des z<0) de façon à les orienter vers le bas avec un angle θ qui résulte de l'équilibre entre leur poids et les forces mécaniques intrinsèques. Cette orientation des éléments mobiles vers le bas, est illustrée sur les figures 6A et 6B. Ainsi, les éléments peuvent être amincis, allégés afin de les rendre beaucoup plus souple et donc beaucoup plus sensible à un champ magnétique extérieur. Dans les cas illustrés aux figures 6A et 6B, un fonctionnement en réflexion ou en transmission, tel que décrit dans le paragraphe précédent, en référence aux figures 5A à 5C, est possible.

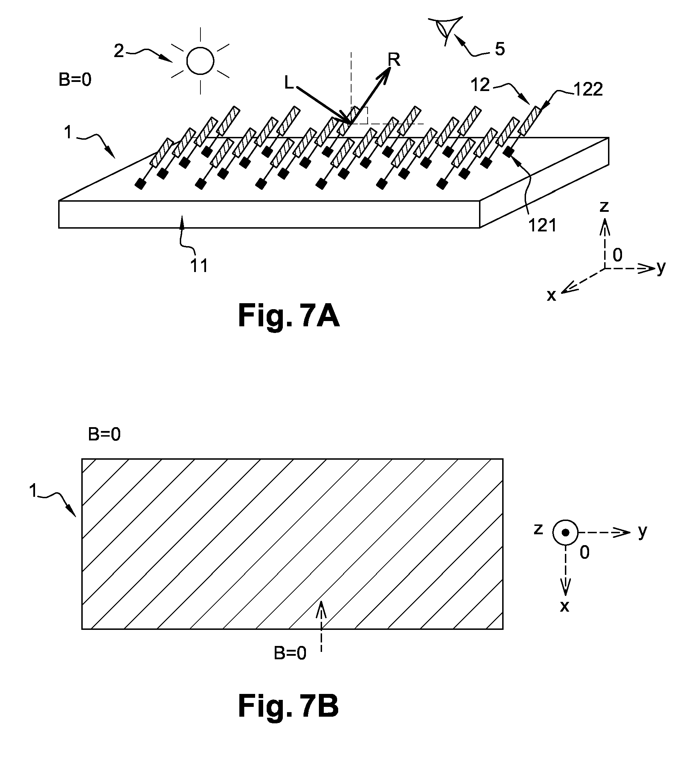

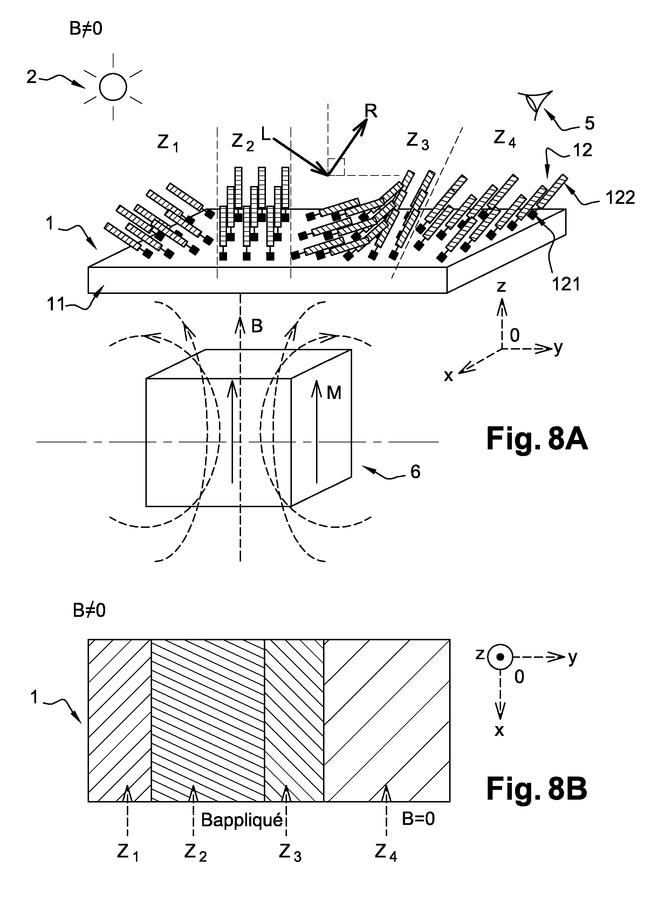

Les figures 7A, 7B, 8A et 8B illustrent, de façon schématique, un exemple d'utilisation en réflexion d'une surface magnéto-optique 1 afin de détecter la présence d'un champ magnétique extérieur B et de le cartographier. La surface 1 comporte un support 11 opaque à la lumière émise par une source lumineuse extérieure 2, disposée du côté de l'axe des z>0. Un récepteur 5 est placé au-dessus de la surface 1, i.e. sur l'axe z>0 pour une hauteur z supérieure à celle de la surface 1. Le récepteur 5 regarde l'image de la surface 1 porteuse des éléments mobiles 12 par-dessus en réflexion. L'objet est éclairé par-dessus, les faisceaux lumineux incidents L se réfléchissent sur les éléments mobiles 12.

Les figures 7A et 7B correspondent au cas où la surface magnéto-optique 1 est soumise à un champ magnétique extérieur nul. Tous les éléments mobiles 12 sont dans une même première position d'équilibre (visible à la figure 7A) et l'image de la surface 1, obtenue par la réflexion par la surface magnéto-optique de la lumière émise par la source 2 est uniforme, tel que visible à la figure 7B.

Les figures 8A et 8B correspondent au cas où la surface magnéto-optique 1 est soumise à un champ magnétique B extérieur non nul, créé par un aimant 6 disposé en-dessous de la surface 1 de la figure 7A. La partie mobile 122 comportant une partie magnétique, elle se déplace sous l'effet du champ magnétique B. Le moment magnétique de la partie magnétique de la partie mobile 122 des éléments mobiles 12 tend à s'aligner avec les vecteurs d'aimantation résultant de l'aimant 6. Il est visible sur la figure 8A que certains éléments mobiles sont restés dans leur première position d'équilibre (à l'extrémité de surface 1 dans la zone Z4), car non soumis au champ B ; tandis que d'autres éléments mobiles 12 sont dans une deuxième position d'équilibre (dans les zones Z1, Z2 et Z3) qui dépend du vecteur d'aimantation auquel ils sont soumis. L'image de la surface 1, observée en réflexion par un récepteur 5 est visible à la figure 8B. Quatre zones (Z1, Z2, Z3 et Z4) sont visibles qui correspondent aux zones du même nom sur la figure 8A.

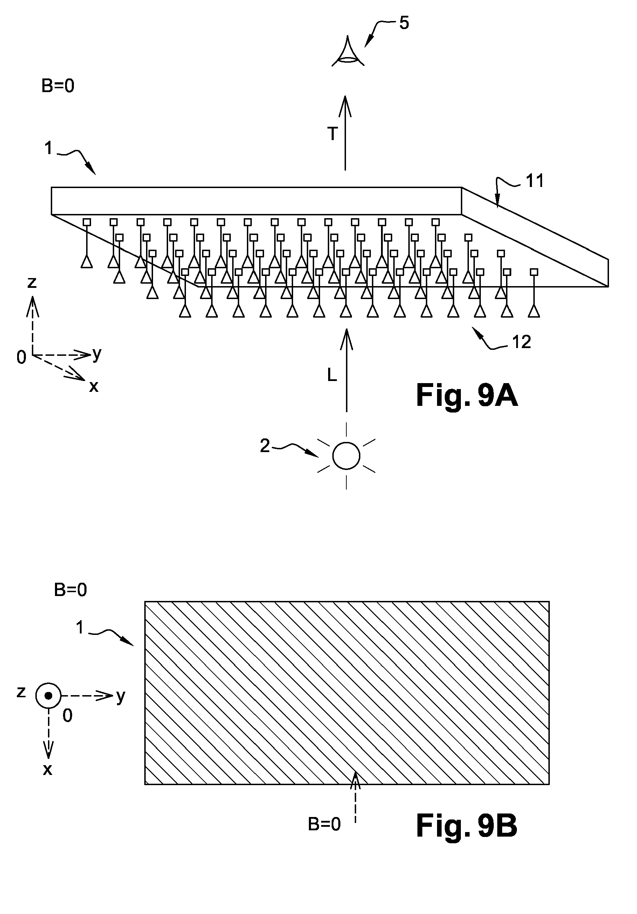

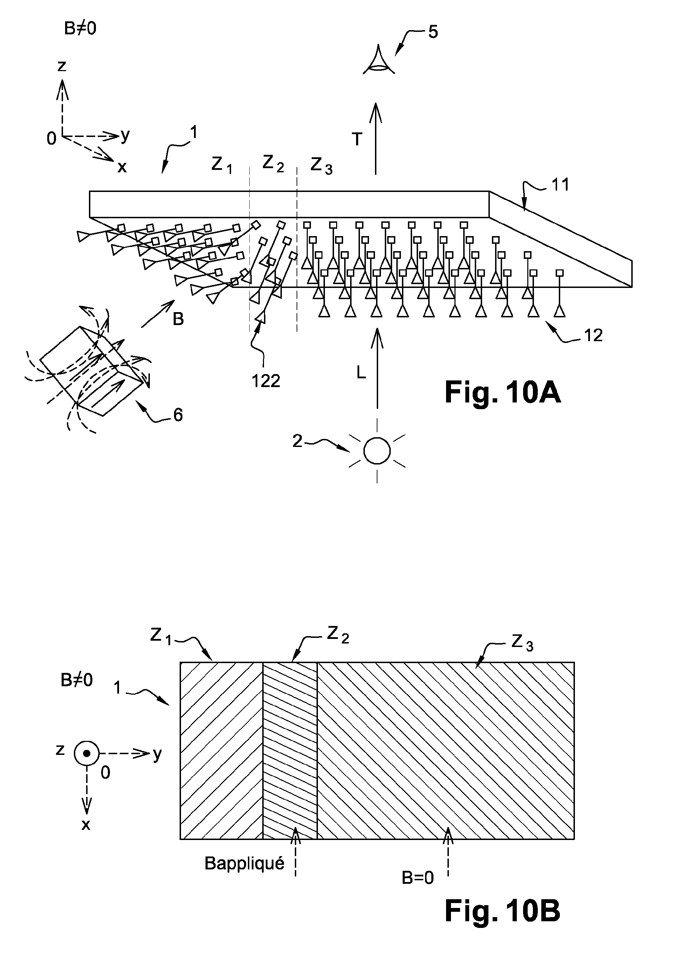

Les figures 9A, 9B, 10A et 10B illustrent, de façon schématique, un exemple d'utilisation en transmission d'une surface magnéto-optique 1 afin de détecter la présence d'un champ magnétique extérieur B et de le cartographier. La surface 1 comporte un support 11 transparent à la lumière émise par une source lumineuse extérieure 2, disposée du côté de l'axe des z<0. Un récepteur 5 est placé du côté de l'axe des z >0, i.e. au-dessus de la surface 1. Le récepteur 5 regarde l'image de la surface 1 porteuse des éléments mobiles 12 par-dessus en transmission. L'objet est éclairé par-dessous, les faisceaux lumineux incidents L se réfléchissent sur les éléments mobiles 12. Les éléments mobiles 12, non transparents, par leur présence, influent sur la quantité de lumière transmise (correspondant au faisceau lumineux transmis T) par le support 11 transparent.

Les figures 9A et 9B correspondent au cas où la surface magnéto-optique 1 est soumise à un champ magnétique B extérieur nul. Tous les éléments mobiles 12 sont dans une même première position d'équilibre (visible à la figure 9A) et l'image de la surface 1, obtenue par la transmission par la surface magnéto-optique de la lumière émise par la source 2 est uniforme, tel que visible à la figure 9B. Dans ce mode de réalisation, les éléments mobiles 12 pendent en-dessous de la surface 1 du côté de la source lumineuse extérieure 2.

Les figures 10A et 10B correspondent au cas où la surface magnéto-optique 1 est soumise à un champ magnétique B extérieur non nul, créé par un aimant 6 disposé en-dessous de la surface 1 de la figure 9A. La partie mobile 122 comportant une partie magnétique, elle se déplace sous l'effet du champ magnétique B. Le moment magnétique de la partie magnétique de la partie mobile 122 des éléments mobiles 12 tend à s'aligner avec les vecteurs d'aimantation résultant de l'aimant 6. Il est visible sur la figure 10A que certains éléments mobiles sont restés dans leur première position d'équilibre (zone Z3), car non soumis au champ B, mais d'autres éléments mobiles 12 sont dans une deuxième position d'équilibre (zones Z1 et Z2) qui dépend du vecteur d'aimantation auquel ils sont soumis. L'image de la surface 1, observée en transmission, par un récepteur 5 est visible à la figure 10B. Trois zones (Z1, Z2 et Z3) sont visibles qui correspondent aux zones du même nom sur la figure 10A.

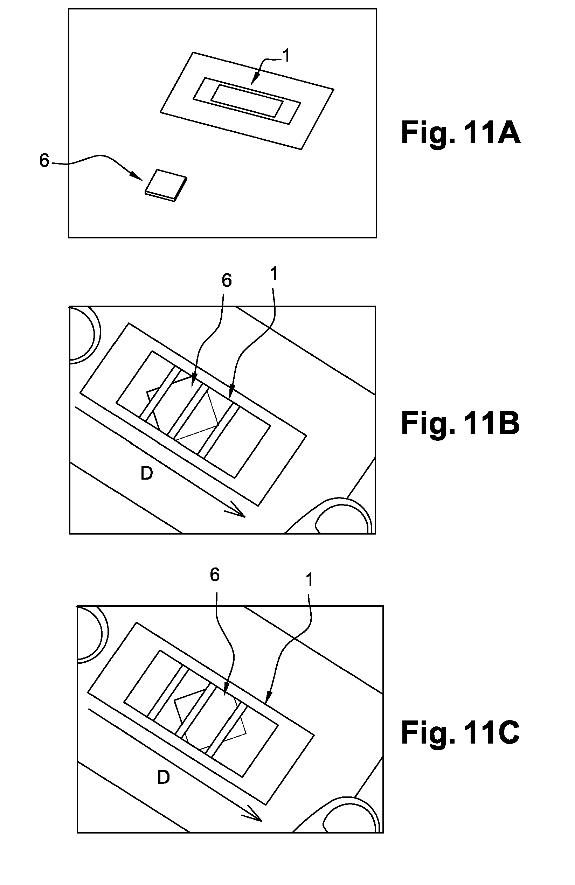

Les figures 11A (champ magnétique extérieur nul) et 11B, 11C (champ magnétique extérieur non nul) sont des photos d'une surface magnéto-optique 1, dont les éléments mobiles ne sont pas visibles individuellement du fait de leur taille microscopique. Un aimant 6 en matériau magnétique NdFeBr (visible à la figure 11A) est déplacé sous la surface 1 (figures 11B et 11C), L'observateur regarde la surface par-dessus, en réflexion. Bien que le support soit opaque, la forme de l'aimant 6 est visible sur la surface 1, il semble être transparent à la lumière. La forme de l'aimant 6 est due au déplacement des éléments mobiles microscopiques sur le support. En comparant les figures 11B et 11C, le déplacement de l'aimant de gauche à droite est visible (selon la flèche D). L'image obtenue est une cartographie du champ magnétique B rayonné par l'aimant 6.

Globalement, le champ magnétique modifie l'image initiale de la surface, dans la première position d'équilibre, pour un champ magnétique nul. La cartographie de champ magnétique montre les variations qualitatives de champ, et peut aussi être interprétée plus finement pour obtenir des informations quantitatives sur le champ magnétique à visualiser, en fonction des géométries et matériaux formant les éléments mobiles de surface. Pour des mesures quantitatives de champ, une chaîne de mesure, incluant un détecteur optique, doit être étalonnée en fonction du champ appliqué.

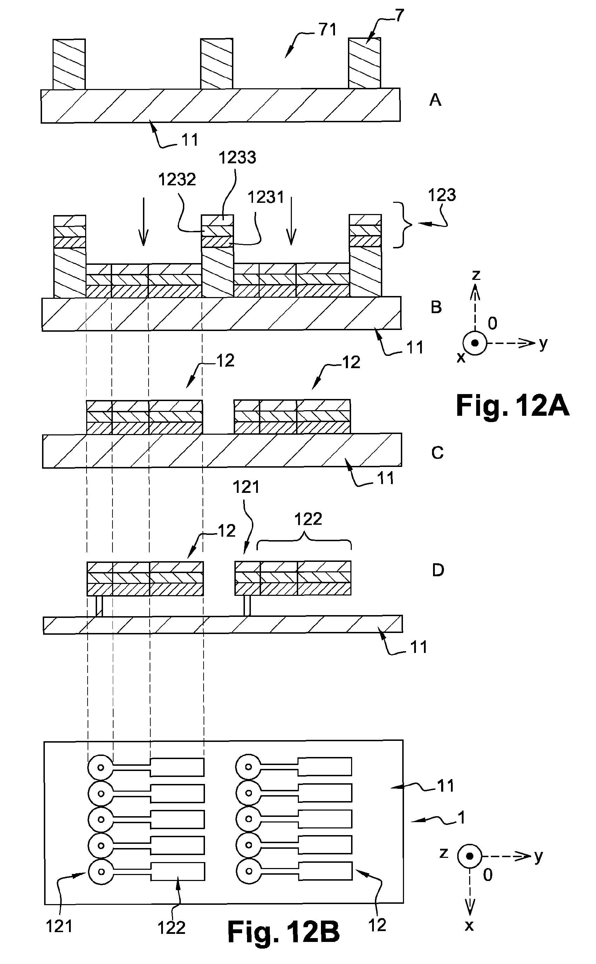

La figure 12A illustre les différentes étapes d'un procédé de fabrication d'une surface magnéto-optique pour une surface magnéto-optique comportant des éléments mobiles de taille micrométrique. Cet exemple de procédé de fabrication met en oeuvre des techniques de microélectronique. Avant l'étape A, a lieu une étape de dépôt sur le support 11 d'une couche de matériau sacrificiel 7. Le matériau sacrificiel 7 peut être une résine photosensible. Le support est ici en silicium.

L'étape A, illustrée sur la figure 12A, est une étape de réalisation d'un réseau de trous 71 dans le matériau sacrificiel, les trous 71 ayant la forme des éléments mobiles dont on veut munir le support 11. Entre les trous 71, se trouvent des plots de matériau sacrificiel qui correspondent à l'espace entre les éléments mobiles d'une surface magnéto-optique. Les techniques utilisées pour former ces trous 71 peuvent être la photolithographie (optique UV, DUV, ou électronique) pour les éléments de taille supérieure à 1µm ; ou dans le cas d'élément de taille nanométrique : la nanoimpression pour les éléments de taille supérieure à 20nm ou un masquage utilisant les techniques de diblock co-polymers pour les éléments de taille supérieure à 3nm. Le motif réalisé par un trou définit un point d'ancrage au support de l'élément mobile et la partie mobile de l'élément mobile.

L'étape B, illustrée sur la figure 12A, est une étape de dépôt sur le support 11 des matériaux 123 constituant les éléments mobiles. Le dépôt des matériaux peut se faire par des techniques de pulvérisation cathodique, d'évaporation, d'électrodéposition ou de spin coating... Dans l'exemple de réalisation illustrée à la figure 12A, l'élément mobile est constitué d'un empilement 123 de couches minces de matériaux, chaque couche mince ayant un rôle particulier :
- une couche 1231 flexible ou formant une couche de protection (pour l'étape D de libération des parties mobiles), formée de matériaux flexibles, et/ou protecteurs d'une couche magnétique 1232 car résistante à la gravure isotrope du Silicium (réalisée lors de l'étape D dans cet exemple de réalisation). De tels matériaux peuvent être de l'aluminium ou du platine ;
- une couche (ou une multicouche) 1232 de matériau(x) magnétique(s), (doux et/ou durs, mono et/ou multicouches e.g. CoFeB ; NiFe ; ou (NiFe/Ru)₇NiFe) avec éventuellement des espaceurs non magnétiques disposés entre les différentes couches de matériaux magnétiques lorsqu'il s'agit d'une multicouche magnétique. Le matériau magnétique peut-être lui-même flexible, selon ses compositions, largeurs, épaisseurs ; et
- une couche réflectrice 1233 non magnétique (optionnelle car la réflexion peut avoir lieu sur le matériau magnétique lui-même).

L'étape C, illustrée à la figure 12A, est une étape de retrait du matériau sacrificiel, ici par dissolution par un solvant approprié. Il est visible à l'étape C que seul les éléments mobiles 12 restent sur le support 11, espacés les uns des autres.

L'étape D, illustrée à la figure 12A, est une étape de libération des parties mobiles 122 du support 11 tout en conservant un point d'ancrage 121 au support 11. Dans l'exemple de la figure 12A, cette étape est réalisée par gravure isotrope du support 11 en silicium. La gravure effectuée par un bombardement ionique, a des effets physiques et chimiques qui enlèvent le silicium, mais sans effets sur les couches protectrices (Exemple Al, Pt..). Le silicium est attaqué de manière isotrope, sous les couches protectrices (ou flexibles) 1231 de la partie magnétique 1232. La partie correspondant au point d'ancrage 121 au support 11 ayant une distance centre-bord plus grande que les distances centre-bord de la partie à libérer (caractéristique visible sur la figure 12B), elle reste fixée par un pilier de silicium sur le substrat, alors que la partie mobile 122 est libérée, détachée du silicium. D'autres techniques de fabrication des éléments mobiles sont envisageables. Par exemple, les éléments mobiles peuvent être nanostructurés (par exemple nanofils de silicium ou nanotubes de carbones) ; réalisés par croissance CVD (Chemical Vapor Deposition) puis recouverts d'un matériau magnétique par dépôt en phase vapeur en incidence oblique.

La figure 12B est une vue de dessus d'une surface 1 magnéto-optique obtenue à la suite des étapes A à D précédemment décrites en référence à la figure 12A.

Les dimensions des éléments mobiles sont de préférence micrométriques ou nanométriques. Dans ce cas, l'objet est fabriqué par les techniques des microélectroniques ou nanoélectroniques, les éléments mobiles étant obtenus par une approche descendante (« top-down approach »), illustrée et décrite ci-dessus en référence à la figure 12A.

Au moins deux éléments mobiles sont répartis sur la surface de l'objet, mais de préférence, sa surface est recouverte d'un nombre important d'éléments mobiles de dimensions très réduites. Le fait d'augmenter la densité de population des éléments mobiles, (le nombre d'éléments par unité de surface, ou le nombre d'éléments par surface observée), améliorera les performances de la surface magnéto-optique. Un nombre important de micro- ou nano-éléments mobiles avec une forte densité sur la surface d'un substrat, est obtenu par les techniques des micro- ou nanoélectroniques. Par exemple, pour un support dont le diamètre peut atteindre plusieurs centimètres, si la surface du support est structurée en lignes et colonnes avec un pas de 3 µm entre chaque élément mobile, si chaque élément mobile est un rectangle de 1µm x 2 µm, placé avec le pas de 3 µm, une surface de 1 cm2 en supporte environ 10⁷, correspondant à 7.8 10⁹ éléments mobiles sur une plaque de diamètre 30 cm.

Au moins deux éléments magnétiques mobiles sont répartis sur la surface de l'objet, mais de préférence, sa surface est recouverte d'un nombre important d'éléments mobiles de dimensions très réduites. Augmenter la densité de population des éléments mobiles, (dans l'absolu le nombre d'éléments par unité de surface, ou un autre critère étant le nombre d'éléments par surface observée), améliorera les performances de l'objet. Un nombre important de micro-ou nano-éléments magnétiques mobiles avec une forte densité sur la surface d'un substrat, est typiquement obtenu par les techniques des micro- ou nanoélectroniques.

Les dimensions de la surface magnéto-optique peuvent être autre que micro- ou nanométriques. Par exemple, vu depuis un satellite, un désert s'étendant sur une surface de 100 km x 100 km, recouvert de 1010 capteurs solaires avec des portions magnétiques mobiles, placés avec un pas de 1 m de côté, fait office de surface magnéto-optique sensible au champ magnétique provenant de sources souterraines, terrestres ou aériennes.

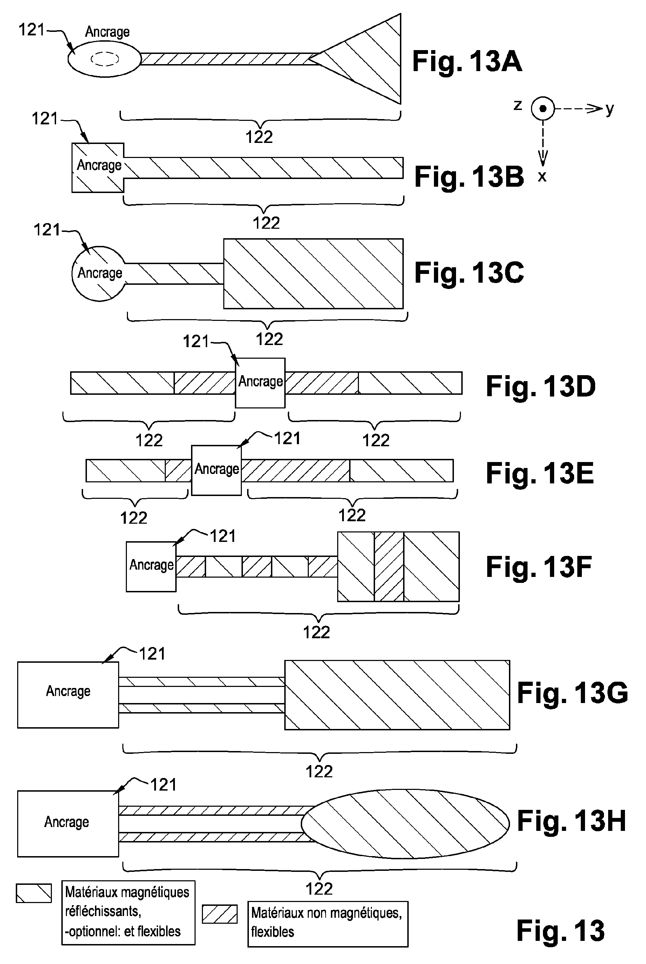

La figure 13 illustre des exemples de réalisation d'éléments mobiles 12 à une ou deux branches, la partie mobile 122 étant soit entièrement magnétique (cas des figures 13B, 13C, 13G), soit en partie couverte de plots magnétiques (cas des figures 13A, 13D, 13E, 13H). Dans le cas de la figure 13B, par exemple, le plot à gauche correspond au point d'ancrage 121 au support, un filament à droite 122 est libre de se mouvoir sous l'effet d'un champ magnétique. Le choix d'un mode de réalisation d'un élément mobile par rapport à un autre se fait selon les valeurs du champ magnétique à détecter, selon la puissance de la source de lumière dont on dispose, selon les valeurs du contraste entre le support et les éléments mobiles, selon la simplicité du processus de fabrication...

Pour ce qui est du positionnement des éléments mobiles sur un support, de multiples configurations sont possibles. Les éléments mobiles peuvent être tous de forme identique, tous de composition (i.e. matériaux les constituant) identique, ou tous différents, ou identiques par sous-ensembles, ou regroupés par sous-ensembles.

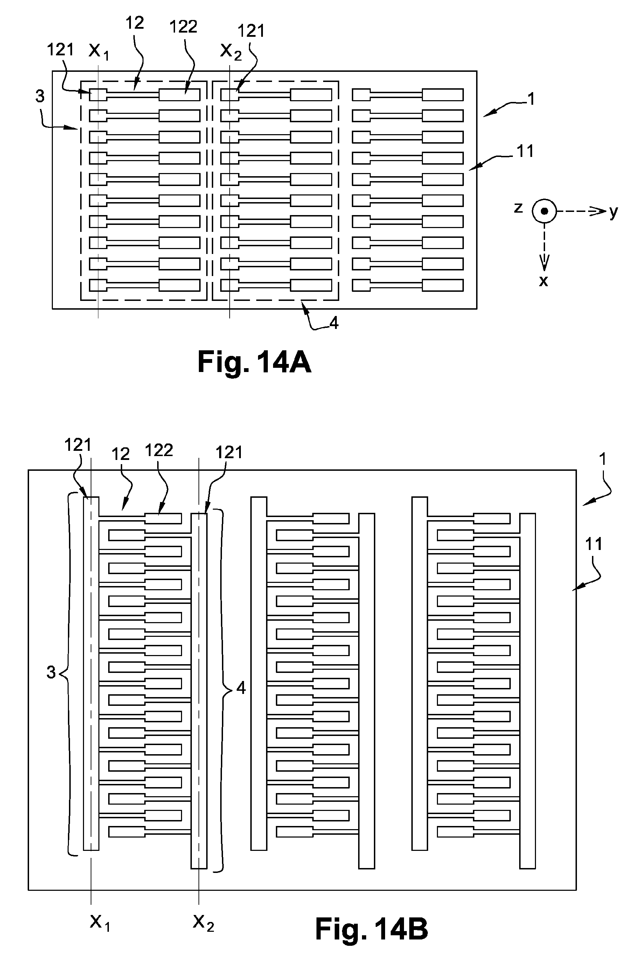

La figure 14A illustre un exemple de configuration possible pour l'agencement d'éléments mobiles 12 sur un support 11 de sorte que lesdits éléments mobiles 12 se déplacent selon un même vecteur sous l'effet d'un champ magnétique extérieur homogène. Les éléments mobiles sont ici tous identiques et répartis en deux sous-ensembles : un premier sous-ensemble 3 comportant des éléments mobiles 12 dont chacun des points d'ancrage 121 au support 11 est aligné selon un premier axe X1. La surface 1 comporte en outre un deuxième sous-ensemble 3 d'éléments mobiles 12 dont chacun des points d'ancrage 121 est aligné selon un deuxième axe X2. En outre chaque élément mobile 12 du premier sous-ensemble 3 est juxtaposé, i.e. disposé côte à côte, à un élément mobile 12 du deuxième sous-ensemble 4. Ainsi les éléments mobiles auront un même comportement s'ils sont soumis à un même champ magnétique extérieur. Le phénomène de modification des propriétés optiques de la surface sous l'action d'un champ magnétique extérieur est plus marqué pour une direction privilégiée d'observation de la surface magnéto-optique 1. Cette direction privilégiée d'observation peut être une observation en incidence oblique dans le cadrant {z>0, y<0}, ou à la verticale de la surface (z>0). L'alignement des points d'ancrage n'est cependant pas obligatoire, l'essentiel est que la déformation des éléments mobiles sous un champ magnétique homogène soit sensiblement la même, au sens vectoriel. On peut ainsi envisager un positionnement des éléments mobiles en quinconce.

La figure 14B illustre un autre exemple de configuration de surface magnéto-optique 1 possible pour l'agencement d'éléments mobiles 12 sur un support 11, les éléments mobiles étant répartis en deux sous-ensembles de sorte que les éléments mobiles du premier sous-ensemble se déplacent selon un même premier vecteur sous l'effet d'un champ magnétique extérieur et que les éléments mobiles du deuxième sous-ensemble se déplacent selon un même deuxième vecteur sous l'effet d'un champ magnétique extérieur. Les éléments mobiles d'un même sous-ensemble sont ici tous identiques et le premier sous-ensemble 3 comporte des éléments mobiles 12 dont chacun des points d'ancrage 121 au support 11 est aligné selon un premier axe X1. La surface 1 comporte en outre un deuxième sous-ensemble 3 d'éléments mobiles 12 (symétriques des éléments du premier sous-ensemble par rapport au plan xOz) dont chacun des points d'ancrage 121 est aligné selon un deuxième axe X2. Sur la figure 14B, chaque sous-ensemble d'éléments mobiles (3 ; 4) est ancré au support 11 par une barre 121 d'ancrage au support : les points d'ancrage sont en commun à l'ensemble des éléments mobiles d'un même sous-ensemble. En outre, les éléments mobiles sont entrecroisés ou entrelacés : un élément mobile du deuxième sous-ensemble 4 est disposé entre deux éléments mobiles du premier sous-ensemble 3. Ainsi la surface active de la surface magnéto-optique est augmentée. Sous l'effet d'un champ magnétique homogène et perpendiculaire au support, tous les éléments mobiles se déforment de la même façon, mais dans les deux sens : les éléments mobiles du premier sous-ensemble se déforment vers {z>0 ; y<0} (premier vecteur de déplacement) et les éléments mobiles du deuxième sous-ensemble se déforment vers {z>0 ; y>0} (deuxième vecteur de déplacement). On peut observer le phénomène de modification des propriétés optiques de la surface dans différentes directions (correspondant à différentes position d'observation du récepteur). Dans le cas où le détecteur est disposé juste au-dessus de la surface (selon les z>0), l'intensité de la lumière observée sera plus élevée dans le cas de la figure 14B, par rapport à la disposition des éléments mobiles de la figure 14A.

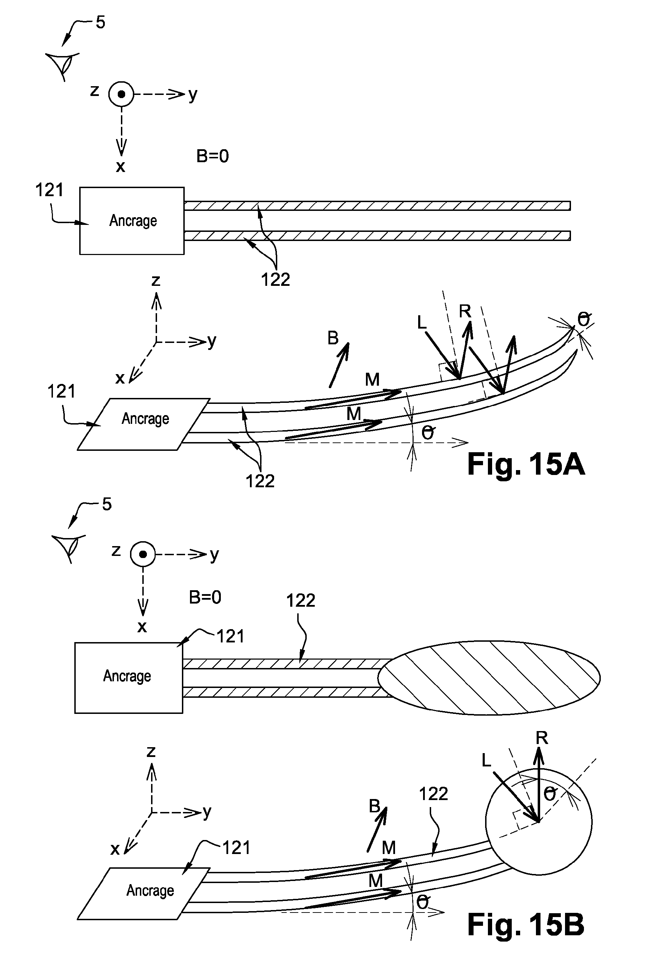

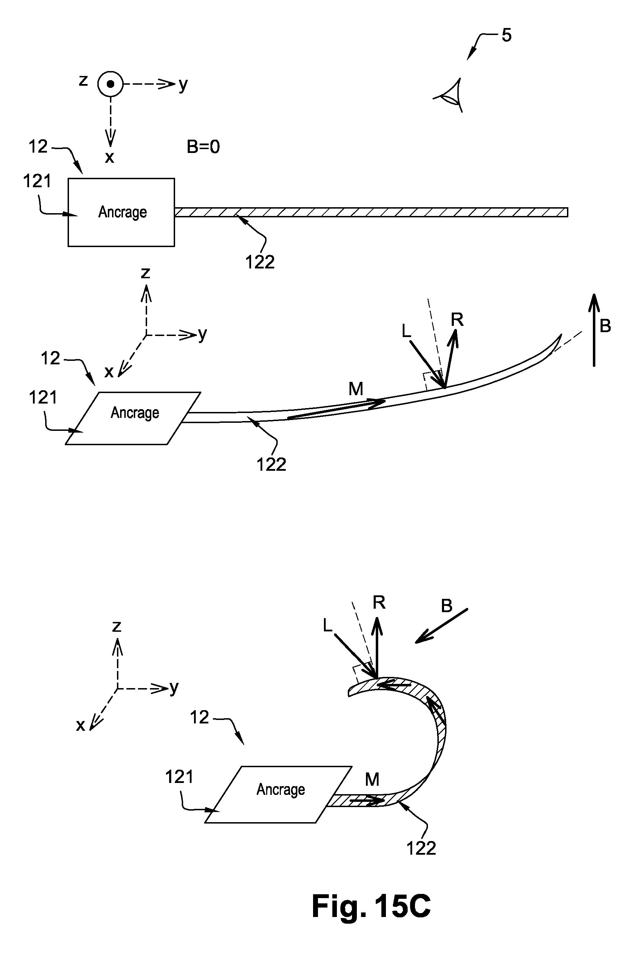

Les figures 15A, 15B et 15C illustrent de façon schématique des exemples de comportement d'éléments mobiles 12 de configurations différentes à un champ magnétique extérieur B (nul et non nul), ainsi que le faisceau lumineux incident L provenant d'une source lumineuse extérieure (non visible) et réfléchi R par l'élément mobile (observable par un récepteur 5). Selon les géométries, et le champ magnétique B extérieur, le recourbement de (ou des) partie(s) mobile(s) 122 des éléments mobiles 12 est plus ou moins important. Les figures 15A et 15B illustrent un exemple d'élément mobile 12 ayant une partie mobile 122 comportant deux branches. La figure 15C illustre un exemple d'élément mobile 12, à une branche constituant la partie mobile 122, très flexible. Lors d'un recourbement complet provoqué par le champ magnétique B, c'est l'envers de la partie mobile 122, retournée, qui devient la surface réfléchissante. Ce dessous peut avoir une surface de couleur différente, augmentant grandement la variation des propriétés optiques de la surface magnéto-optique sur laquelle seraient disposés de tels éléments mobiles 12.

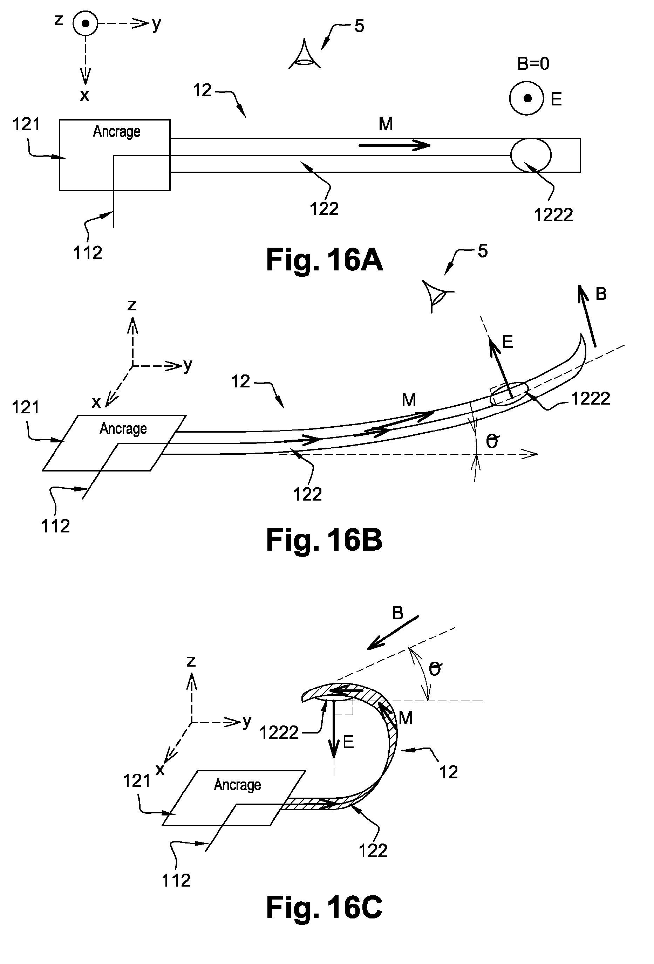

Les figures 16A à 16C illustrent un exemple de réalisation d'un élément mobile 12 comportant un moyen d'émission 1222 de lumière émettant un faisceau lumineux émis E. L'élément mobile comporte un point d'ancrage 121 à un support, une partie mobile 122 en matériau magnétique 1221. Le moyen d'émission 1222 est relié à une source d'alimentation électrique du support (non visible) par un élément de connectique 112 en passant par exemple par le point d'ancrage 121 qui solidarise partie mobile et support. L'élément mobile pourrait aussi être réalisé entièrement dans un matériau conducteur électriquement qui éviterait la nécessité de la présence d'un élément de connectique de type fil. La direction de la lumière émise dépend du champ magnétique appliqué.

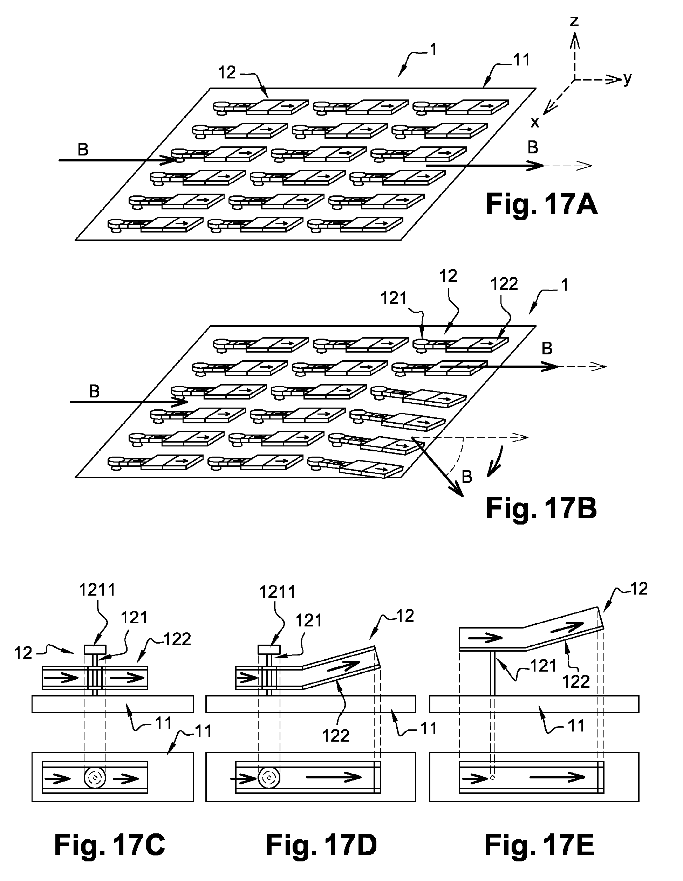

Les figures 17A à 17E illustrent un exemple de réalisation de surface magnéto-optique comportant des éléments mobiles 12 dont le point d'ancrage 121 au support 11 est un axe fixe tel que l'élément mobile 12 est mobile en rotation autour de cet axe fixe 121 sous l'effet d'un champ magnétique extérieur B. Ces éléments mobiles 12 sont capables de rotation dans le plan du support 11. Une telle caractéristique favorise une cartographie des composantes du champ magnétique parallèles à la surface magnéto-optique 1 tel qu'illustré entre la figure 17A et 17B. La figure 17C illustre un élément mobile 12 mobile en rotation autour d'un axe fixe d'ancrage au support 121, l'élément mobile 12 étant symétrique par rapport à cet axe fixe 121. La figure 17D illustre le cas d'un élément mobile 12 mobile en rotation autour d'un axe fixe d'ancrage au support 121, l'élément mobile 12 étant dissymétrique par rapport à cet axe fixe 121. Dans ces deux cas (figures 17C et 17D), l'élément mobile 12 est maintenu à l'axe fixe par un trou pratiqué dans l'élément mobile dans lequel passe l'axe 121 et un chapeau 1211 maintient l'élément mobile 12 à l'axe fixe 121. Dans cet exemple de réalisation, l'axe 121 n'est pas libre en rotation : il y a torsion dans le plan du support. De façon générale, les éléments mobiles peuvent être configurés pour être déformables en torsion et en flexion ou en rotation et en flexion.

Les applications d'une surface magnéto-optique selon l'un des modes de réalisation précédemment décrits sont multiples.

Elle peut constituer un transducteur «magnéto-optique» permettant :
- d'obtenir une information sur un champ magnétique grâce à l'optique ;
- une détection de champ magnétique ;
- une cartographie de champ magnétique ; ou
- une mesure quantitative du champ magnétique.

Elle peut aussi permettre de réaliser un affichage d'informations grâce à l'application d'un champ magnétique permettant de commander le comportement des rayons réfléchis (réflexion séculaire ou diffuse) transmis, ou émis par l'application du champ magnétique. Les directions de réflexion, transmission, ou émission du faisceau optique incident étant modifiées par l'application du champ magnétique. Une telle surface peut être utilisée pour cartographier un champ magnétique dans une zone. On dispose une surface magnéto-optique dans la zone, dans laquelle se trouve le champ magnétique à cartographier, la surface est éclairée par une source lumineuse extérieure (naturelle ou artificielle), et un récepteur observe l'image de la surface. Sous l'effet du champ magnétique, les éléments mobiles vont se déplacer et l'amplitude des déflections locales de la lumière issue de la surface, dues au déplacement des éléments mobiles, est une image de la distribution spatiale du champ magnétique.

Une surface magnéto-optique peut par exemple être utilisée pour la détection d'inhomogénéités de conductivité électriques, par exemple des fractures, dans des matériaux conducteurs électriques, mises en évidence en visualisant des non-homogénéités de champs magnétiques créés par des courants ; ou pour détecter des fuites de courants, par les champs magnétiques qu'elles génèrent ; ou pour détecter la structure en domaines d'un matériau magnétique créant l'apparition de champs magnétiques inhomogènes.

Un assemblage de surfaces magnéto-optiques formant un volume (par exemple un polyèdre : tétraèdre, cube, etc) peut permettre la cartographie d'un champ magnétique 3 dimensions.

Un assemblage de deux surfaces magnéto-optiques comportant chacune un support transparent, couvert d'éléments et plaquée l'une sur l'autre par les faces non recouvertes d'éléments mobiles, ou espacées d'un espaceur transparent, peut permettre la cartographie de champs magnétiques à des altitudes différentes selon un axe perpendiculaire aux surfaces. En vue de la même application, plusieurs surfaces peuvent aussi être empilées les unes sur les autres et maintenues avec suffisamment d'espace laissant les éléments mobiles fonctionner, chacune à leur altitude.

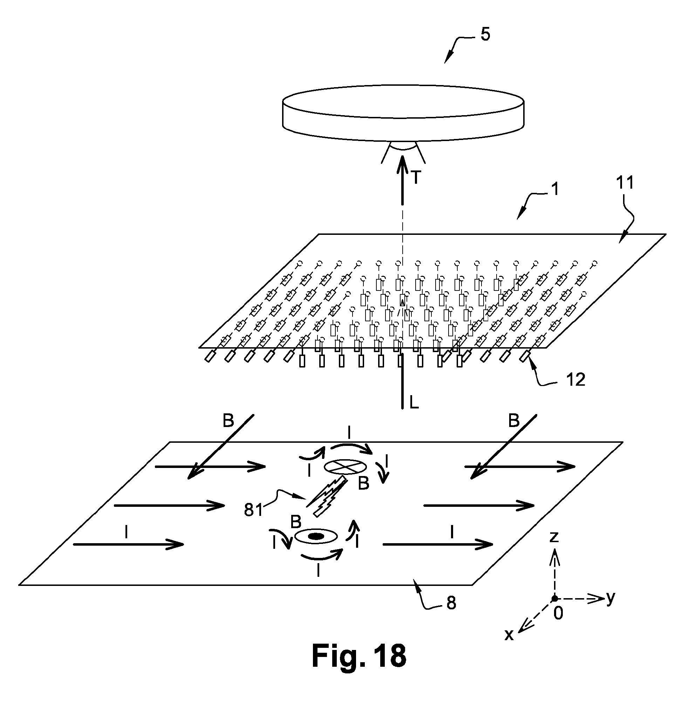

La figure 18 illustre un exemple d'application d'une surface magnéto-optique 1 pour la détection de fracture dans une plaque métallique 8. Cette surface 1 comporte un support 11 transparent à la lumière émise par une source lumineuse extérieure (non visible sur la figure),émettant le faisceau lumineux incident L qui traverse la surface 1, se réfléchit sur la plaque métallique 8, retraverse la surface 1 pour être détecté par le récepteur 5 pour étudier la modification de ses propriétés. La surface 1 est observée par un récepteur 5, ici un microscope qui reçoit le faisceau lumineux transmis T. Les éléments mobiles 12 pendent sous la surface magnéto-optique 1 en vis-à-vis d'une plaque métallique 8. La détection de fracture pourrait aussi se faire en observant les modifications des propriétés en réflexion de la surface 1 (dans ce cas, les éléments mobiles 12 seraient au-dessus de la surface 1). L'avantage de l'étude en transmission est que les éléments mobiles 12 sont au plus près des champs magnétiques à détecter ce qui améliore l'efficacité de la détection de fracture et qu'ils sont plus sensibles au champ, comme vu en référence à la figure 6B. Pour détecter la présence de fracture 81 dans une plaque métallique 8, un courant électrique I est injecté horizontalement dans la plaque 8 (i.e. selon le plan 0xy). Si la plaque 8 est disposée horizontalement (i.e. selon le plan 0xy), le champ magnétique B créé par I au-dessus de la plaque 8 est horizontal. Par contre, une fracture 81 dans la plaque 8 crée une déviation du courant I, qui génère un champ B vertical, pointant vers le haut ou vers le bas autour de la fracture 81. Cette composante verticale de B est détectée par la surface magnéto-optique 1. En effet, les éléments mobiles 12 pendent verticalement par gravité quand B est nul ou dans un champ B vertical (dans cet exemple de réalisation), et sont remontés vers l'horizontale dans un champ B horizontal. La présence d'une fracture 81 entraine ainsi une modification de l'image de la surface 1 observée en transmission par le microscope 5. Un tel procédé de détection de fracture est particulièrement avantageux dans le cas de la détection de micro-fractures (ou nano-fractures) dans une plaque métallique indétectables à l'oeil nu. Au microscope, les éléments mobiles 12 peuvent être individuellement discernables s'ils sont de dimensions micrométriques. S'ils sont nanométriques, ils modifieront le contraste de la surface observée selon leur orientation. Dans tous les cas, selon le récepteur utilisé, les modifications du champ magnétique sont optiquement observables.

Une surface magnéto-optique dont les éléments mobiles sont tous de même forme et de même dimension, peut former un réseau de diffraction d'une lumière émise par une source lumineuse extérieure lorsque le pas entre les éléments mobiles et leur positionnement permettent de diffracter la lumière émise par la source lumineuse. L'intensité des différentes taches de diffraction peut alors être modifiée par l'application d'un champ magnétique.

L'invention n'est pas limitée aux modes de réalisation précédemment décrits en référence aux figures et des variantes pourraient être envisagées sans sortir du cadre de l'invention.

## Revendications

1. Surface magnéto-optique (1) comportant :
- un support (11);
- au moins deux éléments mobiles (12) de dimensions micro- ou nanométriques;
chacun desdits éléments mobiles (12) comportant :
- au moins un point d'ancrage (121) au support (11);
- au moins une partie mobile (122) par rapport au support (11), ladite partie mobile (122) comportant au moins une partie magnétique (1221)
**caractérisée en ce que** le support (11) et lesdits éléments mobiles (12) sont agencés de façon à ce que sous l'effet d'un champ magnétique extérieur, au moins un desdits éléments mobiles (12) se déplace par rapport au support (11) de sorte que les propriétés optiques de la surface magnéto-optique (1) sont modifiées.

2. Surface magnéto-optique (1) selon la revendication 1 **caractérisée en ce que** le support (11) est transparent à la lumière émise par une source lumineuse extérieure et **en ce que** les propriétés optiques de la surface magnéto-optique (1) modifiées sont les propriétés en transmission de ladite lumière.

3. Surface magnéto-optique (1) selon la revendication 1 **caractérisée en ce que** le support (11) est opaque à la lumière émise par une source lumineuse extérieure et **en ce que** les propriétés optiques de la surface magnéto-optique (1) modifiées sont les propriétés en réflexion de ladite lumière.

4. Surface magnéto-optique (1) selon l'une quelconque des revendications précédentes **caractérisée en ce que** la partie mobile (122) par rapport au support (11) de chacun desdits éléments mobiles (12) comporte un moyen d'émission de lumière (1222).

5. Surface magnéto-optique (1) selon la revendication 4 **caractérisée en ce que** le support (11) comporte une source d'alimentation électrique et **en ce que** le moyen d'émission de lumière (1222) de chacun desdits éléments mobiles (12) est relié à la source d'alimentation électrique par un élément de connectique (112).

6. Surface magnéto-optique (1) selon l'une quelconque des revendications précédentes **caractérisée en ce que** la partie mobile (122) de chacun desdits éléments mobiles (12) comporte une partie flexible (1223).

7. Surface magnéto-optique (1) selon l'une quelconque des revendications précédentes **caractérisée en ce que** la partie mobile (122) de chacun desdits éléments mobiles comporte une pluralité de parties flexibles reliées les unes aux autres par des parties moins flexibles.

8. Surface magnéto-optique (1) selon l'une quelconque des revendications précédentes **caractérisée en ce que** la partie mobile (122) de chacun desdits éléments mobiles (12) comporte une partie réfléchissante (1226).

9. Surface magnéto-optique (1) selon l'une quelconque des revendications précédentes **caractérisée en ce que** le point d'ancrage (121) au support (11) est un axe fixe et **en ce que** l'élément mobile (12) est mobile en rotation autour de cet axe fixe sous l'effet du champ magnétique extérieur.

10. Surface magnéto-optique (1) selon l'une quelconque des revendications précédentes **caractérisée en ce que** les éléments mobiles (12) sont agencés de sorte qu'ils se déplacent selon un même vecteur sous l'effet d'un champ magnétique extérieur homogène.

11. Surface magnéto-optique (1) selon l'une quelconque des revendications précédentes **caractérisée en ce qu'**elle comporte :
- un premier sous-ensemble (3) comportant au moins deux éléments mobiles, les éléments mobiles du premier sous-ensemble se déplaçant selon un même premier vecteur sous l'effet d'un champ magnétique extérieur homogène ;
- un deuxième sous-ensemble (4) comportant au moins deux éléments mobiles, les éléments mobiles du deuxième sous-ensemble se déplaçant selon un même deuxième vecteur sous l'effet d'un champ magnétique extérieur homogène.

12. Procédé de fabrication d'une surface magnéto-optique (1) selon l'une quelconque des revendications précédentes **caractérisée en ce qu'**il comporte :
- une étape de dépôt sur le support (11) d'une couche de matériau sacrificiel (7) ;
- une étape de réalisation d'un réseau de trous (71) dans le matériau sacrificiel (7), les trous (71) ayant la forme voulue des éléments mobiles (12);
- une étape de dépôt des matériaux (123) constituant lesdits éléments mobiles (12), lesdits matériaux (123) étant déposés sur l'ensemble du support (11) ;
- une étape de retrait du matériau sacrificiel (7), de façon à ce que seuls les éléments mobiles (12) restent sur le support (11) ; et
- une étape de libération des parties mobiles (122) du support (11) tout en conservant un point d'ancrage (121) au support (11).

13. Procédé de cartographie d'un champ magnétique, ledit champ magnétique étant dans une zone, **caractérisé en ce que** ledit procédé comprend les étapes suivantes :
- une étape au cours de laquelle une surface magnéto-optique (1) selon l'une quelconque des revendications 1 à 11 est disposée dans ladite zone ;
- une étape d'observation de l'image de la surface magnéto-optique (1), l'amplitude des déflections locales de la lumière issue de ladite surface magnéto-optique (1) étant l'image de la distribution spatiale du champ magnétique, ladite surface magnéto-optique (1) étant éclairée par une source lumineuse.

14. Procédé de détection d'inhomogénéité (81) de conductivité électrique dans un objet (8) électriquement conducteur, ledit procédé comportant les étapes suivantes :
- une étape d'injection d'un courant dans l'objet (8) électriquement conducteur ;
- une étape d'observation d'une surface magnéto-optique (1) selon l'une quelconque des revendications 1 à 11, ladite surface magnéto-optique (1) étant disposée au-dessus dudit objet (8) et ladite surface magnéto-optique (1) étant éclairée par une source lumineuse, ladite étape d'observation étant réalisée par un récepteur ;
**caractérisé en ce qu'**une inhomogénéité (81) en une zone de l'objet(8) est détectée par une modification des propriétés optiques de la surface magnéto-optique (1) au niveau de ladite zone de l'objet (8) sous l'action de la modification du champ magnétique engendrée par la déviation du courant par ladite inhomogénéité (81).

15. Réseau de diffraction comportant une surface magnéto-optique (1) selon l'une quelconque des revendications 1 à 11 **caractérisé en ce que** les éléments mobiles (12) ont la même forme et les mêmes dimensions et sont agencés de façon à diffracter une lumière émise par une source lumineuse extérieure.

## Patentansprüche

1. Magnetisch-optische Oberfläche (1), umfassend:
- einen Träger (11);
- wenigstens zwei mobile Elemente (12) mit mikro- oder nanometrischen Abmessungen,;
wobei jedes der mobilen Elemente (12) umfasst:
- wenigstens einen Verankerungspunkt (121) am Träger (11);
- wenigstens einen mobilen Teil (122) im Verhältnis zum Träger (11), wobei der genannte mobile Teil (122) wenigstens einen magnetischen Teil (1221) umfasst,
**dadurch gekennzeichnet, dass**
der Träger (11) und die genannten mobilen Elemente (12) derart angeordnet sind, dass
unter der Wirkung eines äußeren Magnetfeldes wenigstens eines der genannten mobilen Elemente (12) sich im Verhältnis zum Träger (11) derart verschiebt, dass die optischen Eigenschaften der magnetisch-optischen Oberfläche (1) verändert sind.

2. Magnetisch-optische Oberfläche (1) gemäß Anspruch 1, **dadurch gekennzeichnet, dass** der Träger (11) gegenüber von einer äußeren Lichtquelle ausgegebenem Licht transparent ist und dass die abgeänderten optischen Eigenschaften der magnetisch-optischen Oberfläche (1) die Eigenschaften bei der Übertragung des genannten Lichts sind.

3. Magnetisch-optische Oberfläche (1) gemäß Anspruch 1, **dadurch gekennzeichnet, dass** der Träger (11) gegenüber dem von einer äußeren Lichtquelle ausgegebenen Licht blickdicht ist und dass die optischen Eigenschaften der abgeänderten magnetisch-optischen Oberfläche (1) die Eigenschaften beim Widerspiegeln des genannten Lichts sind.

4. Magnetisch-optische Oberfläche (1) gemäß einem der voranstehenden Ansprüche, **dadurch gekennzeichnet, dass** der mobile Teil (122) im Verhältnis zum Träger (11) jedes der genannten mobilen Elemente (12) ein Lichtausgabemittel (1222) umfasst.

5. Magnetisch-optische Oberfläche (1) gemäß Anspruch 4, **dadurch gekennzeichnet, dass** der Träger (11) eine Stromversorgungsquelle umfasst und dass das Lichtausgabemittel (1222) jedes der genannten mobilen Elemente (12) durch ein Anschlusselement (112) an die Stromversorgungsquelle angeschlossen ist.

6. Magnetisch-optische Oberfläche (1) gemäß einem der voranstehenden Ansprüche, **dadurch gekennzeichnet, dass** der mobile Teil (122) jedes der genannten mobilen Elemente (12) einen flexiblen Teil (1223) umfasst.

7. Magnetisch-optische Oberfläche (1) gemäß einem der voranstehenden Ansprüche, **dadurch gekennzeichnet, dass** der mobile Teil (122) jedes der genannten mobilen Elemente eine Vielzahl von flexiblen Teilen umfasst, die durch weniger flexible Teile miteinander verbunden sind.

8. Magnetisch-optische Oberfläche (1) gemäß einem der voranstehenden Ansprüche, **dadurch gekennzeichnet, dass** der mobile Teil (122) jedes der genannten mobilen Elemente (12) einen reflektierenden Teil (1226) umfasst.

9. Magnetisch-optische Oberfläche (1) gemäß einem der voranstehenden Ansprüche, **dadurch gekennzeichnet, dass** der Verankerungspunkt (121) am Träger (11) eine feste Achse ist und dass das mobile Element (12) in Rotation um diese feste Achse unter der Wirkung des externen Magnetfeldes mobil ist.

10. Magnetisch-optische Oberfläche (1) gemäß einem der voranstehenden Ansprüche, **dadurch gekennzeichnet, dass** die mobilen Elemente (12) derart angeordnet sind, dass sie sich unter der Wirkung eines homogenen äußeren Magnetfeldes gemäß einem Vektor verschieben.

11. Magnetisch-optische Oberfläche (1) gemäß einem der voranstehenden Ansprüche, **dadurch gekennzeichnet, dass** sie umfasst:
- eine erste Untergruppe (3), umfassend wenigstens zwei mobile Elemente, wobei sich die mobilen Elemente der ersten Untergruppe gemäß einem und demselben ersten Vektor unter der Wirkung eines homogenen äußeren Magnetfeldes verschieben;
- eine zweite Untergruppe (4), umfassend wenigstens zwei mobile Elemente, wobei die mobilen Elemente der zweiten Untergruppe sich unter der Wirkung eines homogenen äußeren Magnetfeldes gemäß einem und demselben zweiten Vektor verschieben.

12. Herstellungsverfahren einer magnetischoptischen Oberfläche (1) gemäß einem der voranstehenden Ansprüche, **dadurch gekennzeichnet, dass** es umfasst:
- eine Ablagestufe auf dem Träger (11) einer Materialopferstufe (7);
- eine Realisierungsstufe eines Löchernetzes (71) in dem Opfermaterial (7), wobei die Löcher (71) das gewünschte Volumen der mobilen Elemente (12) haben;
- eine Ablagerungsstufe der Materialien (123), die die genannten mobilen Elemente (12) bilden, wobei die genannten Materialien (123) auf der Gruppe des Trägers (11) aufgebracht sind;
- eine Abnehmstufe des Opfermaterials (7) derart, dass nur die mobilen Elemente (12) auf dem Träger (11) bleiben; und
- eine Freigabestufe der mobilen Teile (122) des Trägers (11) bei gleichzeitiger Beibehaltung eines Verankerungspunktes (121) am Träger (11).

13. Kartographieverfahren eines Magnetfeldes, wobei das genannte Magnetfeld sich in einem Bereich befindet, **dadurch gekennzeichnet, dass** das genannte Verfahren die folgenden Stufen umfasst:
- eine Stufe, in deren Verlauf eine magnetischoptische Oberfläche (1) gemäß Anspruch 1 bis 11 in dem genannten Bereich angeordnet ist;
- eine Beobachtungsstufe des Bildes der magnetisch-optischen Oberfläche (1), wobei die Amplitude der lokalen Ableitungen des aus der genannten magnetischoptischen Oberfläche (1) stammenden Lichts das Bild der räumlichen Verteilung des magnetischen Feldes ist, wobei die genannte magnetisch-optische Oberfläche (1) durch eine Lichtquelle beleuchtet ist.

14. Erfassungsverfahren einer Inhomogenität (81) der elektrischen Leitfähigkeit in einem elektrisch leitfähigen Objekt (8), wobei das Verfahren die folgenden Stufen umfasst:
- eine Einschussstufe eines Stroms in das elektrisch leitende Objekt (8);
- eine Beobachtungsstufe einer magnetischoptischen Oberfläche (1) gemäß Anspruch 1 bis 11, wobei die genannte magnetisch-optische Oberfläche (1) oberhalb des genannten Objekts (8) angeordnet ist und die genannte magnetisch-optische Oberfläche (1) durch eine Lichtquelle beleuchtet ist, wobei die genannte Beobachtungsstufe durch einen Empfänger realisiert ist;
**dadurch gekennzeichnet, dass** eine Inhomogenität (81) in einem Bereich des Objekts (8) durch eine Änderung der optischen Eigenschaften der magnetischoptischen Oberfläche (1) auf der Höhe des genannten Bereichs des Objekts (8) unter der Wirkung der Änderung des durch die Ableitung des Stroms durch die genannte Inhomogenität (81) erzeugten Magnetfelds erfasst wird.

15. Diffraktionsnetz, umfassend eine magnetischoptische Oberfläche (1) gemäß Anspruch 1 bis 11, **dadurch gekennzeichnet, dass** die mobilen Elemente (12) dieselbe Form und dieselben Abmessungen haben und derart angeordnet sind, dass ein von einer äußeren Lichtquelle ausgegebenes Licht gebeugt wird.

## Claims

1. Magneto-optic surface (1) comprising:
- a support (11);
- at least two mobile elements (12) with micro- or nanometric dimensions;
each of said mobile elements (12) comprising:
- at least one anchor point (121) to the support (11);
- at least one moving part (122) free to move relative to the support (11), said moving part (122) comprising at least one magnetic part (1221),
**characterised in that** the support (11) and said mobile elements (12) are arranged such that under the effect of an external magnetic field, at least one of said mobile elements (12) moves relative to the support (11) such that the optical properties of the magneto-optic surface (1) are modified.

2. Magneto-optic surface (1) according to claim 1, **characterised in that** the support (11) is transparent to light emitted by an external light source and **in that** the optical properties of the modified magneto-optic surface (1) are transmission properties of said light.

3. Magneto-optic surface (1) according to claim 1, **characterised in that** the support (11) is opaque to light emitted by an external light source and **in that** the optical properties of the modified magneto-optic surface (1) are reflection properties of said light.

4. Magneto-optic surface (1) according to any one moving of the previous claims, **characterised in that** the part (122) free to move relative to the support (11) of each of said mobile elements (12) comprises a light emission means (1222).

5. Magneto-optic surface (1) according to claim 4, **characterised in that** the support (11) comprises an electrical power supply source and **in that** the light emission means (1222) of each of said mobile elements (12) is connected to the electrical power supply source by a connection element (112).

6. Magneto-optic surface (1) according to any one of the previous claims, **characterised in that** the moving part (122) of each of said mobile elements (12) comprises a flexible part (1223).

7. Magneto-optic surface (1) according to any one of the previous claims, **characterised in that** the moving part (122) of each of said mobile elements comprises a plurality of flexible parts connected to each other by less flexible parts.

8. Magneto-optic surface (1) according to any one of the previous claims, **characterised in that** the moving part (122) of each of said mobile elements (12) comprises a reflecting part (1226).

9. Magneto-optic surface (1) according to any one of the previous claims, **characterised in that** the anchor point (121) to the support (11) is a fixed axis and **in that** the mobile element (12) is free to move in rotation about this fixed axis under the effect of the external magnetic field.

10. Magneto-optic surface (1) according to any one of the previous claims, **characterised in that** the mobile elements (12) are arranged such that they move along the same vector under the effect of a homogeneous external magnetic field.

11. Magneto-optic surface (1) according to any one of the previous claims, **characterised in that** it comprises:
- a first subassembly (3) comprising at least two mobile elements, the mobile elements of the first subassembly moving along the same first vector under the effect of a homogeneous external magnetic field;
- a second subassembly (4) comprising at least two mobile elements, the mobile elements of the second subassembly moving along the same second vector under the effect of a homogeneous external magnetic field.

12. Method of manufacturing a magneto-optic surface (1) according to any one of the previous claims, **characterised in that** it comprises:
- a step to deposit a layer of sacrificial material (7) on the support (11);
- a step to make a network of holes (71) in the sacrificial material (7), the holes (71) having the required shape of the mobile elements (12);
- a step to deposit materials (123) forming said mobile elements (12), said materials (123) being deposited on the entire support (11);
- a step to remove the sacrificial material (7) such that only the mobile elements (12) remain on the support (11); and
- a step to release the moving parts (122) from the support (11) while keeping an anchor point (121) to the support (11).

13. Method for mapping a magnetic field, said magnetic field being in a zone, **characterised in that** said method comprises the following steps:
- a step in which a magneto-optic surface (1) according to any one of claims 1 to 11 is arranged in said zone;
- a step to observe the image of the magneto-optic surface (1), the amplitude of the local deflections of light output from said magneto-optic surface (1) being the image of the spatial distribution of the magnetic field, said magneto-optic surface (1) being illuminated by a light source.

14. Method of detecting non-homogeneity (81) of electrical conductivity in an electrically conducting object (8), said method comprising the following steps:
- a step to inject a current into the electrically conducting object (8);
- a step to observe a magneto-optic surface (1) according to any one of claims 1 to 11, said magneto-optic surface (1) being arranged above said object (8) and said magneto-optic surface (1) being illuminated by a light source, said observation step being done by a receiver;
**characterised in that** a non-homogeneity (81) in a zone of the object (8) is detected by a modification of the optical properties of the magneto-optic surface (1) at the said zone of the object (8) under the action of the modification of the magnetic field generated by deviation of the current by said non-homogeneity (81).

15. Diffraction grating comprising a magneto-optic surface (1) according to any one of claims 1 to 11, **characterised in that** the mobile elements (12) have the same shape and the same dimensions and are arranged so as to diffract light emitted by an external light source.
